# DEMANDE DE BREVET EUROPEEN

(11) **EP 4 621 847 A1**
(43) Date de publication de la demande: **24.09.2025**
(21) Numéro de dépôt: 25159150.9
(22) Date de dépôt: 20.02.2025
(51) Int. Cl.: H01L 25/16, H10H 29/14, H10H 20/01, H10H 20/831

(54) **DISPOSITIF OPTOELECTRONIQUE COMPORTANT UNE DIODE ELECTROLUMINESCENTE SUPERPOSEE A UN PHOTODETECTEUR**

(30) Priorité: 04.03.2024 FR 2402159
(71) Demandeur: Commissariat à l'Energie Atomique et aux Energies Alternatives, 75015 Paris (FR)
(72) Inventeur: SIMON, Julia, 38054 Grenoble Cedex 09 (FR); BALLOT, Clément, 38054 Grenoble Cedex 09 (FR); ABADIE, Quentin, 38054 Grenoble Cedex 09 (FR)
(74) Mandataire: Brevalex

(57) **Abrégé**

L'invention porte sur dispositif optoélectronique comportant un circuit de contrôle, un pixel comprenant un photodétecteur, une diode électroluminescente et une région intermédiaire intercalée entre le photodétecteur et la diode électroluminescente. Le photodétecteur est sensible à une longueur d'onde de détection λ₂. La diode électroluminescente comprend un empilement actif de longueur d'onde de coupure λ_{c} inférieure à λ₂ et une électrode enterrée intercalée entre un empilement d'interconnexion du circuit et l'empilement actif, et recouvre une surface de détection du photodétecteur. Le dispositif comprend en outre un via traversant de part en part l'empilement actif, se prolongeant jusqu'à l'empilement d'interconnexion ; un contact électrique traversant de part en part l'empilement actif, en contact avec l'électrode enterrée ; un chemin électrique connectant électriquement l'électrode enterrée au circuit de contrôle et comportant le contact électrique traversant et le via. La région intermédiaire est dépourvue de métal et l'électrode enterrée est transparente à λ₂.

## Description

### DOMAINE TECHNIQUE

Le domaine de l'invention est celui des dispositifs optoélectroniques combinant une fonction d'émission de lumière et de détection d'un flux lumineux. L'invention concerne par exemple un écran d'affichage interactif comprenant un capteur matriciel et une matrice de diodes électroluminescentes pilotés par un circuit de contrôle. L'invention concerne également un procédé de fabrication d'un tel dispositif.

### ÉTAT DE LA TECHNIQUE ANTÉRIEURE

Les écrans d'affichage ont bénéficié des avancées technologiques dans le domaine des diodes électroluminescentes pour l'éclairage. Ainsi, il existe par exemple des écrans de toutes dimensions mettant en oeuvre des diodes électroluminescentes à base de nitrure de gallium (GaN). Parmi ceux-ci, les micro-écrans comprennent généralement un grand nombre de diodes électroluminescentes de dimensions typiquement inférieures à 10 µm, disposées en matrice. Chaque diode électroluminescente constitue un pixel du micro-écran. Les micro-écrans à base de nitrure de gallium (GaN) présentent une forte luminance, une bonne résolution, sont compacts et généralement peu consommateurs de courant électrique.

Récemment, de nouveaux écrans, dits écrans interactifs, ont vu le jour. Une catégorie d'écran interactif allie une matrice de diodes électroluminescentes à un capteur de photons matriciel, tous deux alimentés et contrôlés par un circuit de contrôle. Ceux-ci permettent d'adresser de nouvelles applications nécessitant une réponse de l'écran interactif lui-même et/ou d'un système dans lequel l'écran interactif est intégré, en fonction d'un flux lumineux détecté et/ou mesuré par le capteur matriciel. Le capteur de photons matriciel est un composant optoélectronique comportant plusieurs photodétecteurs disposés en matrice. Lorsque chaque photodétecteur du capteur de photons est agencé en vis-à-vis d'une diode électroluminescente respective, l'écran interactif est compact et a une bonne résolution.

La demande de brevet EP4148810 est un tel exemple d'écran interactif à base de diodes électroluminescentes GaN. Dans ce document, un circuit intégré comporte un premier substrat et plusieurs niveaux interconnexions sur le premier substrat. Le premier substrat intègre en outre un capteur de photons comportant une matrice de photodiodes. Une matrice de diodes électroluminescentes est réalisée sur un deuxième substrat à partir de couches épitaxiées à base d'AlInGaN et/ou d'InGaN et/ou d'AIGaN et/ou de GaN. Les diodes électroluminescentes sont séparées les unes des autres par des grilles en matériau conducteur, chacune isolée électriquement des diodes électroluminescentes. Ces dernières sont donc individualisées.

Le premier et le deuxième substrats comportent respectivement des premiers plots de connexion et des deuxièmes plots de connexion métalliques affleurant respectivement une face d'une première couche diélectrique et une face d'une deuxième couche diélectrique. Un report du deuxième substrat sur le premier substrat est réalisé par collage direct hybride des premier et des deuxième plots de connexion et, des première et deuxième couches diélectriques. Pour cela, un taux d'occupation des premiers et deuxièmes plots de connexion est compris entre 60 % et 90 % sur chacune des faces. A l'issue de cette étape, chaque diode électroluminescente, préalablement individualisée avant le report, est disposée en regard d'une photodiode et séparée de celle-ci par un premier plot de connexion collé à un deuxième plot de connexion, lui-même en contact avec une deuxième électrode de la diode électroluminescente. La deuxième électrode est métallique et réfléchissante. Un ensemble constitué d'un premier plot d'interconnexion, d'un deuxième plot d'interconnexion et d'une deuxième électrode constitue une électrode enterrée individuelle de la diode électroluminescente. Chaque électrode enterrée est une électrode d'anode d'une diode électroluminescente individuelle. Les diodes électroluminescentes ont une cathode commune en oxyde d'indium-étain (ITO).

Dans cette configuration, la photodiode reçoit un flux lumineux incident sur une partie d'une surface de détection qui n'est pas située à l'aplomb de l'électrode enterrée, le flux lumineux incident pouvant être issu de la diode électroluminescente en vis-à-vis ou d'une scène externe. Par conséquent, la photodiode reçoit une partie seulement du flux lumineux incident, celle qui n'est pas obturée par l'électrode enterrée. La partie du flux lumineux incident est par exemple reçue au travers d'un trou pratiqué dans la deuxième électrode, concentrique avec des trous plus larges pratiqués dans le premier et le deuxième plots de connexion. Une augmentation de la surface de la deuxième électrode induit un accroissement de l'efficacité quantique de la diode électroluminescente, au détriment de la quantité de flux atteignant la photodiode.

Il en résulte un compromis entre une sensibilité du capteur de photons et une efficacité d'émission de la matrice de diodes électroluminescentes.

### EXPOSÉ DE L'INVENTION

L'invention a pour objectif de remédier au moins en partie aux inconvénients de l'art antérieur, et plus particulièrement de proposer un dispositif optoélectronique comportant une diode électroluminescente superposée à un photodétecteur de sensibilité à un flux lumineux incident augmentée, sans compromettre l'efficacité d'émission de la diode électroluminescente. Le dispositif optoélectronique de l'invention est particulièrement avantageux pour une utilisation dans un système de type laboratoire sur puce.

Pour cela, l'objet de l'invention est un dispositif optoélectronique, comportant un substrat ; un circuit de contrôle intégré dans et/ou sur le substrat comportant un empilement d'interconnexion ; une matrice d'au moins un pixel. Chaque pixel comprend un photodétecteur, une diode électroluminescente et une région intermédiaire intercalée entre le photodétecteur et la diode électroluminescente. Chaque pixel est tel que le photodétecteur est sensible à une longueur d'onde de détection λ₂ et comprend une surface de détection s'étendant dans un plan sensiblement parallèle à un plan principal du substrat. La diode électroluminescente comprend un empilement actif de longueur d'onde de coupure λ_{c} inférieure à la longueur d'onde de détection λ₂. L'empilement actif comporte une première et une deuxième couches dopées de types opposés. La diode électroluminescente comprend en outre une électrode enterrée en contact avec la deuxième couche dopée. La diode électroluminescente est agencée de telle façon que l'électrode enterrée est intercalée entre l'empilement d'interconnexion et l'empilement actif, et recouvre la surface de détection. Chaque pixel est tel que la région intermédiaire est délimitée par la surface de détection et s'étend depuis la surface de détection jusqu'à l'empilement actif. Le dispositif optoélectronique comprend en outre un via traversant de part en part l'empilement actif et se prolongeant jusqu'à un niveau d'interconnexion de l'empilement d'interconnexion ; un contact électrique traversant de part en part l'empilement actif, en contact avec l'électrode enterrée ; un chemin électrique connectant électriquement l'électrode enterrée au circuit de contrôle et comportant le contact électrique traversant et le via. La région intermédiaire est dépourvue de métal, L'électrode enterrée est transparente à la longueur d'onde de détection λ₂.

Certains aspects préférés mais non limitatifs de ce dispositif optoélectronique sont les suivants.

Le dispositif optoélectronique peut être tel que pour chaque pixel, la diode électroluminescente peut comporter une région active s'étendant entre les première et deuxième couches dopées dans un plan sensiblement parallèle au plan principal ; une tranchée conductrice pouvant entourer la région active et la région intermédiaire, pouvant traverser de part en part l'empilement actif et pouvant se prolonger jusqu'à un niveau d'interconnexion de l'empilement d'interconnexion ; et une électrode surfacique en contact avec la première couche dopée, connectée électriquement au circuit de contrôle par la tranchée conductrice.

Le dispositif optoélectronique peut être tel que la tranchée conductrice est revêtue d'un miroir.

La matrice peut comporter plusieurs pixels, et l'électrode surfacique peut être une électrode commune à tous les pixels.

Les tranchées conductrices de deux pixels voisins peuvent avoir une partie en commun.

La région intermédiaire peut comprendre une couche intermédiaire de fonction optique pouvant s'étendre parallèlement au plan principal du substrat.

Pour chaque pixel, l'électrode enterrée peut être en un oxyde d'indium-étain, en un oxyde de zinc dopé à l'aluminium ou en dioxyde d'étain.

Pour chaque pixel, l'électrode surfacique peut être en un oxyde d'indium-étain, en un oxyde de zinc dopé à l'aluminium.

Le dispositif optoélectronique peut comprendre en outre une couche surfacique de fonction optique disposée sur une face du dispositif optoélectronique opposée au substrat.

La couche surfacique de fonction optique peut être une couche absorbante comportant une ouverture en regard la surface de détection.

Le dispositif optoélectronique peut comprendre en outre un élément chauffant disposé sur une face du dispositif optoélectronique opposée au substrat, l'élément chauffant pouvant comporter une ouverture en regard la surface de détection.

La longueur d'onde de détection λ₂ peut appartenir au spectre visible et la diode électroluminescente peut être apte à émettre un flux lumineux dans la gamme des UVA.

L'invention porte également sur un procédé de fabrication d'un dispositif optoélectronique comportant une diode électroluminescente et un photodétecteur sensible à une longueur d'onde de détection λ₂. Le procédé comprend la fourniture d'un premier ensemble comprenant, dans l'ordre, un premier substrat, un empilement semi-conducteur et une couche conductrice inférieure, tel que l'empilement semi-conducteur comprend une première couche dopée d'un premier type de conductivité et une deuxième couche dopée d'un deuxième type de conductivité opposé au premier type de conductivité, intercalée entre la première couche dopée et le premier substrat, et tel que la couche conductrice inférieure est en contact physique avec la deuxième couche dopée.

Le procédé comprend la fourniture d'un deuxième ensemble comprenant un deuxième substrat, un circuit de contrôle et le photodétecteur, tel que le circuit de contrôle est intégré dans et/ou sur le deuxième substrat et comporte un empilement d'interconnexion.

Le procédé comprend le report d'une face du premier ensemble opposée au premier substrat sur une face du deuxième ensemble opposée au deuxième substrat par collage direct mettant en oeuvre une couche de collage transparente à la longueur d'onde de détection λ₂.

Le procédé comprend la mise à nue de la première couche dopée comportant un retrait du premier substrat, pour obtenir un empilement actif comportant la première couche dopée et la deuxième couche dopée.

Le procédé comprend la gravure d'un premier trou mettant en oeuvre un alignement du premier trou par rapport à un élément du deuxième ensemble, de telle sorte que le premier trou traverse de part en part l'empilement actif et se prolonge jusqu'à un niveau d'interconnexion de l'empilement d'interconnexions.

Le procédé comprend la gravure d'un deuxième trou mettant en oeuvre un alignement du deuxième trou par rapport à un élément du deuxième ensemble, de telle sorte que le deuxième trou traverse de part en part l'empilement actif avec arrêt sur la couche conductrice inférieure.

Le procédé comprend la passivation du premier trou et du deuxième trou pour obtenir, respectivement, un premier trou passivé et un deuxième trou passivé.

Le procédé comprend le remplissage des premier et deuxième trous passivés avec un métal pour obtenir, respectivement, un via et un contact électrique.

Le procédé comprend la formation d'une ligne conductrice isolée électriquement de l'empilement actif et en contact avec le contact électrique et le via.

Le procédé comprend la formation d'une région active de la diode électroluminescente dans l'empilement actif en regard d'une surface de détection du photodétecteur, postérieurement à l'étape de collage, mettant en oeuvre un alignement de la région active par rapport à un élément du deuxième ensemble.

La formation de la région active peut comprendre une sous-étape de gravure d'une tranchée pouvant traverser de part-en-part l'empilement actif et pouvant se prolonger jusqu'à un niveau d'interconnexion de l'empilement d'interconnexion.

La couche de collage peut inclure une couche intermédiaire de fonction optique.

### BRÈVE DESCRIPTION DES DESSINS

D'autres aspects, buts, avantages et caractéristiques de l'invention apparaîtront mieux à la lecture de la description détaillée suivante de formes de réalisation préférées de celle-ci, donnée à titre d'exemple non limitatif, et faite en référence aux dessins annexés sur lesquels :
la figure 1A est une vue schématique en coupe d'un premier ensemble comprenant un empilement semi-conducteur sur un premier substrat ;
la figure 1B est une vue schématique en coupe d'un deuxième ensemble comprenant un deuxième substrat, un circuit de contrôle et un photodétecteur ;
les figures 2A à 2H sont des vues schématiques en coupe d'étapes intermédiaires d'un premier procédé de fabrication d'un premier dispositif optoélectronique selon l'invention ;
les figures 2I et 2J sont respectivement, une vue schématique en coupe latérale et une vue schématique en coupe de dessus du premier dispositif optoélectronique ;
la figure 3A est une vue schématique en coupe d'une première variante du dispositif optoélectronique selon l'invention ;
la figure 3B est une vue schématique en coupe d'une deuxième variante du dispositif optoélectronique selon l'invention ;
la figure 3C est une vue schématique en coupe d'une troisième variante du dispositif optoélectronique selon l'invention ;
la figure 3D est une vue schématique en coupe d'une quatrième variante du dispositif optoélectronique selon l'invention ;
la figure 3E est une vue schématique en coupe d'une cinquième variante du dispositif optoélectronique selon l'invention ;
la figure 4A est une vue schématique en coupe d'une variante du deuxième ensemble ;
la figure 4B est une vue schématique en coupe d'une sixième variante du premier dispositif optoélectronique obtenu à l'issu du premier procédé de fabrication appliqué à la variante du deuxième ensemble ;
les figures 5A et 5B sont des vues schématiques en coupe d'étapes intermédiaires d'un deuxième procédé de fabrication d'un deuxième dispositif optoélectronique selon l'invention ;
les figures 5C et 5D sont respectivement, une vue schématique en coupe latérale et une vue schématique de dessus d'un deuxième dispositif optoélectronique issu du deuxième procédé de fabrication ;

### EXPOSÉ DÉTAILLÉ DE MODES DE RÉALISATION PARTICULIERS

Sur les figures et dans la suite de la description, les mêmes références représentent les éléments identiques ou similaires. De plus, les différents éléments ne sont pas représentés à l'échelle de manière à privilégier la clarté des figures. Par ailleurs, les différents modes de réalisation et variantes ne sont pas exclusifs les uns des autres et peuvent être combinés entre eux. Sauf indication contraire, les termes « sensiblement », « environ », « de l'ordre de » signifient à 10% près, et de préférence à 5% près. Par ailleurs, les termes « compris entre ... et ... » et équivalents signifient que les bornes sont incluses, sauf mention contraire.

L'invention porte sur un dispositif optoélectronique comportant un substrat, un circuit de contrôle intégré dans et/ou sur le substrat qui comprend un empilement d'interconnexions, une diode électroluminescente et un photodétecteur. La diode électroluminescente est superposée au photodétecteur et alimentée et/ou contrôlée par le circuit de contrôle. Le photodétecteur est agencé et configuré pour détecter un flux lumineux, dit incident, à une longueur d'onde de détection λ₂, traversant la diode électroluminescente pour atteindre une surface de détection du photodétecteur. Ceci est en particulier possible parce que la diode électroluminescente comporte un empilement semi-conducteur de longueur d'onde de coupure λ_{c} inférieure à la longueur d'onde de détection λ₂. Elle émet donc un flux lumineux, dit émis, à une longueur d'onde d'émission λ₁ inférieure à la longueur d'onde de détection λ₂.

La diode électroluminescente comporte un empilement de couches semiconductrices et une électrode enterrée agencée entre l'empilement de couches semiconductrices et la surface de détection.

L'électrode enterrée est transparente à la longueur d'onde λ₂ et n'est pas en contact physique avec un niveau d'interconnexion de l'empilement d'interconnexions. Elle est connectée électriquement à un niveau d'interconnexion de l'empilement d'interconnexions par un chemin électrique qui comporte un contact électrique, un via et une ligne conductrice recouvrant une face de l'empilement de couches semiconductrices opposée à l'électrode enterrée. Le chemin électrique peut être aussi plus complexe et comprendre un ensemble d'interconnexions électriques connecté électriquement au contact électrique et au via, et recouvrant la face de l'empilement de couches semiconductrices opposée à l'électrode enterrée. Le contact électrique et le via traversent tous deux, de part-en-part, l'empilement de couches semiconductrices. Le contact électrique est en contact physique sur une partie supérieure de l'électrode enterrée opposée à l'empilement d'interconnexions. Le via se prolonge jusqu'à un niveau d'interconnexion de l'empilement d'interconnexions. Ainsi, une augmentation de la surface de détection du photodétecteur entraîne une augmentation du flux lumineux incident détecté sans devoir diminuer des dimensions latérales de l'électrode enterrée. En d'autres termes, la sensibilité du photodétecteur est augmentée sans perte d'efficacité d'émission de la diode électroluminescente.

L'invention concerne également un procédé de fabrication d'un tel dispositif optoélectronique. Il comprend le report d'un premier ensemble sur un deuxième ensemble. Le premier ensemble comporte, dans l'ordre, un premier substrat, un empilement semi-conducteur et une couche conductrice. Le deuxième ensemble comporte un deuxième substrat, un circuit de contrôle et un photodétecteur. Le circuit de contrôle est intégré dans et/ou sur le deuxième substrat et comprend un empilement d'interconnexion. La couche conductrice est transparente à la longueur d'onde de détection λ₂ du photodétecteur. Elle se retrouve intercalée entre l'empilement semi-conducteur et le photodétecteur après le report.

Le procédé inclut une étape, postérieure au report, de formation d'une région active de la diode électroluminescente dans l'empilement semi-conducteur, par alignement sur un élément du deuxième ensemble, ceci afin de positionner la région active en regard du photodétecteur. Le procédé comprend en outre une étape, postérieure au report, de formation d'un via et d'une tranchée conductrice traversant de part en part l'empilement semiconducteur et se prolongeant jusqu'à des plots de connexion respectifs de l'empilement d'interconnexions. Le via et la tranchée sont destinées à connecter électriquement la diode électroluminescente au circuit de contrôle. La formation du via et de la tranchée conductrice met en oeuvre un alignement sur un élément du deuxième ensemble. Ainsi les alignements, d'une part, de la région active de la diode électroluminescente par rapport au photodétecteur, et d'autre part du via et de la tranchée conductrice par rapport aux plots de connexion, sont précis. Par conséquent une surface utile de détection du photodétecteur est augmentée, d'autant plus qu'il est possible de prévoir des plots de connexion de tailles réduites. La sensibilité du photodétecteur est donc augmentée.

La surface de détection d'un photodétecteur délimite la plus petite surface plane du photodétecteur traversée par l'ensemble des photons d'un flux lumineux incident aptes à générer un signal détecté par un circuit de lecture du photodétecteur.

Une région active d'un dispositif optoélectronique est une partie du dispositif destinée à émettre ou à détecter un rayonnement lumineux d'intérêt. La région active d'une diode électroluminescente est la (ou les) région(s) à l'intérieur de laquelle (desquelles) les porteurs de charges issus d'électrodes de la diode électroluminescente se recombinent pour produire des photons. La région active d'une photodiode est la (ou les) région(s) à l'intérieur de laquelle (desquelles) un photon est apte à générer un signal détecté par un circuit de lecture de la photodiode.

Dans la description, il est donné à « métal » son sens couramment utilisé dans le domaine technique de l'invention. Par soucis de clarté, il est cependant précisé que les oxydes métalliques, tels que l'oxyde d'indium-étain (ITO), l'oxyde de zinc dopé à l'aluminium (AZO) ou le dioxyde d'étain (SnO2) ne sont pas des métaux.

Dans la description, il est donné à « empilement d'interconnexions » son sens couramment utilisé dans le domaine technique de l'invention. Par soucis de clarté, il est cependant précisé qu'un empilement d'interconnexions comprend des couches appelées « niveaux d'interconnexions », deux-à-deux séparées par des couches appelées « couches inter-niveaux ». Les niveaux d'interconnexions comportent des lignes métalliques séparées par un matériau isolant électrique. Les couches inter-niveaux comportent des via métalliques connectant électriquement une ligne métallique d'un niveau d'interconnexion à une autre ligne métallique d'un niveau d'interconnexion voisin ou à un substrat sur lequel l'empilement d'interconnexions repose. Le via sont séparés par un matériau isolant électrique.

Par couche, on entend ici et pour la suite de la description, une étendue constituée d'une ou plusieurs sous-couches d'un matériau, dont l'épaisseur suivant un axe z est inférieure, par exemple dix fois, voire vingt fois, à ses dimensions longitudinales de largeur et de longueur dans un plan (x, y) perpendiculaire à l'axe z. Une couche peut être structurée. Lorsqu'elle consiste en plusieurs sous-couches, les sous-couches peuvent être en des matériaux différents. La ou les sous-couches s'étendent dans des plans sensiblement parallèles au plan (x, y). Une couche conforme est une catégorie spécifique de couche formée en contact avec une surface non plane, pour laquelle l'épaisseur, mesurée perpendiculairement à la surface, est sensiblement constante, par exemple à 10 % près, voire à 5 % près.

La longueur d'onde de coupure λ_{c} d'un matériau semiconducteur est la longueur d'onde maximale d'un photon incident qui peut être absorbé pour exciter un électron de la bande de valence à la bande de conduction du matériau semiconducteur, créant ainsi un électron libre et un trou. Cette absorption se produit lorsque l'énergie du photon incident est égale ou supérieure à l'énergie de la bande interdite du matériau semiconducteur, également connue sous le nom de bande interdite ou énergie de gap. La longueur d'onde de coupure λ_{c} d'un empilement semiconducteur est égal à la valeur minimale des longueurs d'onde de coupure de tous les matériaux semiconducteurs que constituent l'empilement semiconducteur.

Un premier élément est aligné par rapport à un deuxième élément, si la formation du premier élément implique une sous-étape de photolithographie mettant en oeuvre un repérage du deuxième élément suivi d'un processus d'alignement sur la base de ce repérage. Le deuxième élément peut être un ensemble de marques d'alignements typiques utilisées par des outils de photolithographie. L'alignement est dit du premier ordre, ou primaire, lorsque la formation du premier élément met en oeuvre la sous-étape de photolithographie. L'alignement est dit du deuxième ordre, ou secondaire, lorsque la sous-étape de photolithographie fait partie d'une étape de formation d'un élément intermédiaire sur lequel le premier élément est aligné au premier ordre. Il est dit d'ordre supérieur lorsqu'il est ni primaire, ni secondaire. Un alignement primaire est plus précis qu'un alignement secondaire, c'est-à-dire que la position relative du premier élément par rapport au deuxième élément et à par rapport à tout autre élément formé en même temps que le deuxième élément est plus précise avec un alignement primaire qu'avec un alignement secondaire. Un alignement d'ordre secondaire est plus précis qu'un alignement d'ordre supérieur. Le premier élément peut être un masque obtenu par une étape de photolithographie supplémentaire. On dit alors que l'étape de photolithographie supplémentaire est alignée par rapport au deuxième élément.

Des modes de réalisation particuliers vont être décrits se rapportant à un dispositif optoélectronique comportant une diode électroluminescente superposée à un photodétecteur. Cependant, ces modes de réalisation peuvent être adaptés à d'autres dispositifs optoélectroniques, par exemple à un capteur multispectral comportant un photodétecteur supplémentaire à la place de la diode électroluminescente.

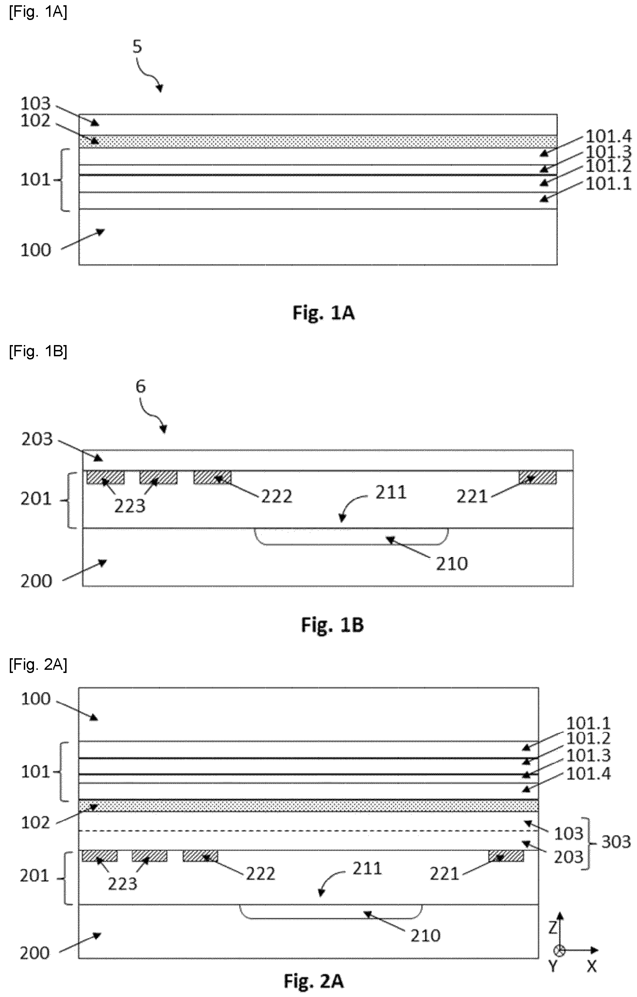

Un premier procédé de fabrication conduisant à un premier mode de réalisation est ci-dessous décrit en lien avec les figures 2A à 2J.

En figure 2A, un premier ensemble est reporté sur un deuxième ensemble. Les premier et deuxième ensembles sont respectivement représentés sur les vues en coupe des figures 1A et 1B. Les premier et deuxième ensembles peuvent par exemple chacun être fournis, tout ou en partie, par une entreprise de fonderie de semi-conducteurs

Le premier ensemble 5 comporte dans l'ordre un premier substrat 100, un empilement semiconducteur 101, une couche conductrice inférieure 102 et une couche de collage supérieure 103. L'empilement semiconducteur 101 est en contact physique avec le premier substrat 100 et la couche conductrice inférieure 102. La couche de collage supérieure 103 est en contact physique avec la couche conductrice inférieure 102.

L'empilement semiconducteur 101 est un empilement de couches semiconductrices. Il comporte une première couche dopée 101.2 d'un premier type de conductivité et une deuxième couche dopée 101.4 d'un deuxième type de conductivité opposé au premier type de conductivité. La première couche dopée 101.2 est intercalée entre la deuxième couche dopée 101.4 et le premier substrat 100. L'empilement semiconducteur 101 peut être crû par épitaxie sur le premier substrat 100. Le cas échéant, il peut comprendre une couche tampon 101.1 servant à l'adaptation d'un paramètre de maille de la première couche dopée 101.2 avec un paramètre de maille du premier substrat 100.

Alternativement, l'empilement semiconducteur 101 peut être crû par épitaxie sur un substrat temporaire et reporté sur le premier substrat 100, par exemple par collage direct de la première couche dopée 101.2 sur une face du premier substrat 100. Par exemple, une couche dopée de type p est épitaxiée sur le substrat temporaire destinée à devenir la deuxième couche dopée 101.4 de l'empilement semiconducteur 101; une couche intrinsèque est épitaxiée sur la couche dopée de type p ; et une couche dopée de type n est épitaxiée sur la couche intrinsèque destinée à devenir la première couche dopée 101.2 de l'empilement semiconducteur 101. Le cas échant, l'empilement semiconducteur 101 peut comprendre une couche tampon 101.1, en contact avec la première couche dopée 101.2 et le premier substrat 100, servant de couche de collage. Il peut par exemple s'agir d'un collage oxyde-oxyde, ou silicium-silicium, ou encore nitrure de silicium-nitrure de silicium. Le couche de collage peut comporter une interface de collage. Cette alternative est par exemple privilégiée pour obtenir une première couche dopée 101.2 en nitrure de gallium (GaN) de type p.

L'empilement semiconducteur 101 comprend un matériau semiconducteur cristallin à gap direct, dont la valeur d'énergie de gap est apte à permettre une émission d'un flux lumineux à une longueur d'onde d'émission λ₁.

Les première et deuxième couches dopées 101.2, 101.4 sont en des matériaux semiconducteurs. L'empilement semiconducteur 101 peut comprendre une couche active 101.3 semiconductrice, intercalée entre la première couche dopée 101.2 et la deuxième couche dopée 101.4, et en contact physique avec ces deux couches. La couche active 101.3 peut par exemple comprendre plusieurs sous-couches semiconductrices d'énergies de gap différentes pour réaliser des puits quantiques. Elle peut être non-intentionnellement dopée ou faiblement dopé de type p ou n.

Les première et deuxième couches dopées 101.2, 101.4 et la couche active 101.3 peuvent par exemple être en des matériaux semiconducteurs choisis parmi du nitrure de gallium, du phosphure de gallium, de l'arséniure de gallium, et du phosphure d'indium.

Dans le cadre non limitatif particulier de l'exemple de procédé décrit ci-dessous, la première couche dopée 101.2 est une couche dopée de type n en nitrure de gallium (GaN). La deuxième couche dopée 101.4 est une couche dopée de type p en nitrure de gallium (GaN). Le premier substrat 100 est en silicium, par exemple une plaque de silicium de 150 mm, 200 mm ou 300 mm de diamètre. La couche tampon 101.1 comporte une sous-couche en nitrure d'aluminium (AIN) en contact physique avec le premier substrat 100 et une succession de bicouches GaN/AIGaN, les sous-couches d'AIGaN ayant des concentrations en aluminium d'autant plus faibles qu'elles sont éloignées du premier substrat 100. La couche active 101.3 comporte des puits quantiques à base d'AlGaN dont la composition est adaptée pour une émission de lumière dans la gamme des UVA.

Par soucis de clarté, on qualifie ci-après certains éléments de la description par leur fonction de destination résultant du choix particulier de types de dopage des couches ci-dessus. Cette qualification ne doit en aucun cas être interprétée comme une limitation. Ainsi, par exemple, une tranchée de cathode peut accueillir une tranchée conductrice connectant la cathode de la diode électroluminescente, dans le cas particulier décrit ci-dessous, ou l'anode de la diode électroluminescente si la première couche dopée 101.2 et la deuxième couche dopée 101.4 sont dopées respectivement dopées d'un type p et d'un type n.

Le deuxième ensemble 6 comporte un deuxième substrat 200, un circuit de contrôle et un photodétecteur 210. Le deuxième substrat 200 est par exemple en silicium. Il a avantageusement des dimensions identiques au premier substrat 100. Par exemple, les premier et deuxième substrats peuvent être tous deux des plaques de 150 mm, 200 mm ou 300 mm. Le circuit de contrôle est intégré sur une face, dite avant, du deuxième substrat 200 et éventuellement dans le deuxième substrat 200. Il peut être de type CMOS. Il comporte un empilement d'interconnexion 201 reposant sur une face avant du deuxième substrat 200, par exemple en contact avec la face avant.

L'empilement d'interconnexions 201 comporte au moins un niveau d'interconnexion. L'empilement d'interconnexions 201 comprend ici un plot de connexion anode 221 et un plot de connexion cathode 222 agencés dans un niveau d'interconnexion de l'empilement d'interconnexions 201. Les plots de connexion anode et cathode 221, 222 sont en métal, par exemple en cuivre. Dans cet exemple, le niveau d'interconnexion comportant les plots de connexion anode et cathode 221, 222 est le dernier niveau d'interconnexion de l'empilement d'interconnexions 201, c'est-à-dire le plus éloigné du deuxième substrat 200. Avantageusement, l'empilement d'interconnexions 201 peut comprendre une couche de passivation en un matériau diélectrique, par exemple en nitrure de silicium (SiN), comportant une face de l'empilement d'interconnexions 201 opposée au deuxième substrat 200. Dans ce cas, le circuit de contrôle et/ou le photodétecteur 210 ne sont préférentiellement pas testés avant l'étape de report de la figure 2A.

Le deuxième ensemble 6 comporte en outre une couche de collage inférieure 203 reposant sur l'empilement d'interconnexions 201 d'un coté de l'empilement d'interconnexions 201 opposé au deuxième substrat 200. La couche de collage inférieure 203 peut être la couche de passivation de l'empilement d'interconnexions 201 ou une couche supplémentaire déposée sur la couche de passivation, avantageusement préalablement polie.

Le photodétecteur 210 comprend une surface de détection 211 sensiblement parallèle à la face avant du deuxième substrat 200. De préférence, la surface de détection 211 est en regard d'une région de l'empilement d'interconnexions 201 dépourvue de métal, c'est-à-dire que l'empilement d'interconnexions 201 n'a pas de lignes métalliques ou de via à l'aplomb de la surface de détection. La surface de détection est ici au voisinage de la face avant du deuxième substrat 200.

Le photodétecteur 210 est sensible à une longueur d'onde de détection λ₂, par exemple comprise dans le spectre visible ou proche infra-rouge, par exemple égale à 630 nm. En outre, il peut être également sensible à la longueur d'onde d'émission λ₁. Le circuit de contrôle est connecté électriquement au photodétecteur 210 et intègre des fonctions d'alimentation du photodétecteur 210, et de lecture de charges générées dans le photodétecteur 210.

Le deuxième ensemble 6 peut comporter plusieurs photodétecteurs 210, par exemple disposés en une matrice s'étendant parallèlement à la face avant du deuxième substrat 200. L'empilement d'interconnexions 201 peut comprendre en outre un ou plusieurs plots de connexion supplémentaires 223, par exemple disposés en bordure de la matrice de photodétecteurs 210. En figure 1B, deux plots de connexion supplémentaires 223 sont représentés dans le même niveau d'interconnexion que les plots de connexion anode et cathode 221, 222. Les plots de connexion supplémentaires 223, s'ils existent, et les plots de connexion anode et cathode 221, 222 sont ci-après appelés collectivement les plots de connexion 221, 222, 223.

Le deuxième ensemble 6 peut être par exemple, comme représenté ici, un capteur d'images à illumination par la face avant (Front Side Illumination, ou FSI, en anglais). Il peut être aussi un capteur d'images par la face arrière (Back Side Illumination, ou BSI, en anglais). Dans ce cas, le deuxième substrat 200 est intercalée entre l'empilement d'interconnexions 201 et la couche de collage inférieure 203. La couche de collage inférieure 203 peut résulter d'un dépôt ou d'une oxydation thermique du deuxième substrat 200.

L'étape de report de la figure 2A peut être avantageusement un collage direct par mise en contact d'une face à assembler de la couche de collage supérieure 103 opposée au premier substrat 100 sur une face à assembler de la couche de collage inférieure 203 opposée au deuxième substrat 200. Les couches de collage supérieure et inférieure 103, 203 sont transparentes à la longueur d'onde de détection λ₂, et peuvent être en outre transparentes à la longueur d'onde d'émission λ₁. Elles transmettent par exemple au moins 50 % d'une lumière incidente en incidence normale à la longueur d'onde de détection λ₂ et/ou d'émission λ₁, ou préférentiellement au moins 90 %, voire au moins 95 %.

Les collages directs mis en oeuvre dans le cadre de l'invention peuvent être de tous types connus. Il peut s'agir d'un collage direct par adhésion moléculaire. Dans ce cas, le collage résulte de liaisons chimiques qui s'établissent entre les faces assemblées. Plusieurs types de collage par adhésion moléculaire existent. Ils diffèrent notamment par des conditions de température, de pression, d'atmosphère et/ou de traitements préalables à la mise en contact des faces à assembler. Il peut s'agir, par exemple, d'un collage à température ambiante, hydrophile ou hydrophobe, avec ou sans activation préalable par plasma des faces à assembler, suivi éventuellement d'un traitement thermique de renforcement de l'interface de collage. Il peut s'agir également d'un collage par diffusion atomique (« Atomic diffusion bonding » ou ADB, en anglais) ou d'un collage par activation de surface (« Surface-activated bonding » ou SAB, en anglais).

Dans le cadre d'un collage direct lors de l'étape de report de la figure 2A, les couches de collage supérieure et inférieure 103, 203 peuvent être toutes deux en oxyde de silicium, en nitrure de silicium ou en silicium amorphe. Les couches de collage supérieure et inférieure 103, 203 sont ici en oxyde de silicium et ont chacune une épaisseur comprise entre 300 nm et 600 nm. Leurs faces à assembler ont été polies préalablement au report pour obtenir un état de rugosité compatible avec un collage direct par adhésion moléculaire. Un traitement thermique de consolidation de l'interface de collage après mise en contact des couches de collage supérieure et inférieure 103, 203 est appliqué, à une température comprise entre 300 °C et 400 °C. A l'issu de l'étape de report de la figure 2A, les couches de collage supérieure et inférieure 103, 203 forment une couche de collage 303 unique.

La couche conductrice inférieure 102 est transparente à la longueur d'onde de détection λ₂, et peut être en outre transparente à la longueur d'onde d'émission λ₁. Elle transmet par exemple au moins 50 % d'une lumière incidente en incidence normale à la longueur d'onde de détection λ₂ et/ou d'émission λ₁, ou préférentiellement au moins 90 %, voire au moins 95 %. La couche conductrice inférieure 102 peut être en un oxyde métallique, par exemple en oxyde d'indium-étain (ITO), en oxyde de zinc dopé à l'aluminium (AZO) ou en dioxyde d'étain (SnO2). Dans cet exemple, la couche conductrice inférieure 102 est en oxyde d'indium-étain (ITO) et a une épaisseur comprise entre 40 nm et 120 nm.

On définit ici et pour la suite de la description un repère direct tridimensionnel orthogonal (X, Y, Z), où les axes X et Y forment un plan parallèle à un plan principal du deuxième substrat 200, où l'axe X est un axe du plan de coupe des figures 2A à 2K, des figures 3A à 3E, des figures, 4A, 4B, 5A, 5B, 5C, et où l'axe Z est orienté de manière sensiblement orthogonale au plan principal du deuxième substrat 200, depuis le deuxième substrat 200 vers l'empilement d'interconnexions 201 et la couche de collage 303. Dans la suite de la description, les termes « vertical » et « verticalement » s'entendent comme étant relatifs à une orientation sensiblement parallèle à l'axe Z, et les termes « horizontal » et « horizontalement » comme étant relatifs à une orientation sensiblement parallèle au plan (X, Y). Par ailleurs, les termes « inférieur » et « supérieur » s'entendent comme étant relatifs à un positionnement croissant lorsqu'on s'éloigne du deuxième substrat 200 suivant la direction +Z. Dans le repère (X, Y, Z), une couche, un empilement ou un substrat s'étendent depuis une face supérieure jusqu'à une face inférieure, toutes deux parallèles au plan (X, Y). La face supérieure et/ou la face inférieure peuvent être structurées.

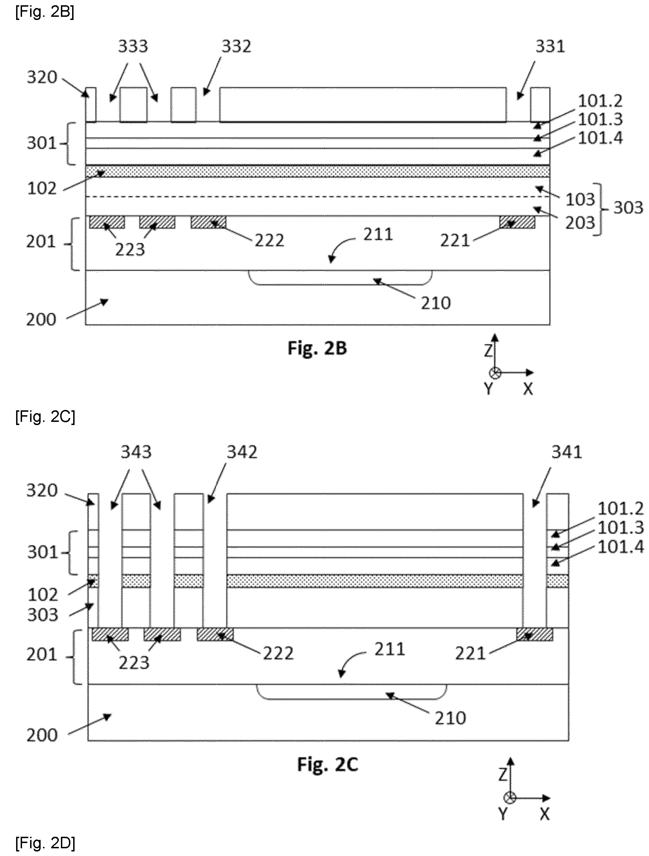

En figure 2B, le premier substrat 100 est retiré, par exemple, par une succession de sous-étapes de meulage et/ou de polissage et/ou de gravure humide. Dans l'exemple particulier de la figure 2B, le premier substrat 100 en silicium est retiré par une succession de sous-étapes de meulage de plus en plus fin, suivi par une gravure chimique humide sélective par rapport à l'AIN.

La couche tampon 101.1 optionnelle est ensuite retirée pour mettre à nue la couche dopée de type n 101.2, par exemple par gravure sèche et/ou par électro-polissage. A l'issu du retrait du premier substrat 100 et de l'éventuel retrait de la couche tampon 101.1 si elle existe, la partie restante de l'empilement semiconducteur 101 est un empilement semiconducteur, dit actif, 301, qui a une longueur d'onde de coupure λ_{c}. L'empilement actif 301 a typiquement une épaisseur égale à 1 µm.

Un masque dur 320 est ensuite déposé sur la couche dopée de type n 101.2 de l'empilement actif 301. Il peut être en oxyde de silicium (SiO), en nitrure de silicium (SiN) ou en oxynitrure de silicium (SiON). Dans cet exemple particulier, il est en oxyde de silicium et a une épaisseur comprise entre 1 µm et 1,5 µm, par exemple égale à 1,2 µm.

Une ouverture d'anode 331 et une ouverture de cathode 332 sont gravées dans le masque dur 320 à l'aplomb, respectivement, du plot de connexion anode 221 et du plot de connexion cathode 222, de façon à ce qu'elles traversent de part en part le masque dur 320. Il est par exemple possible de définir les ouvertures d'anode et de cathode 331, 332 par une sous-étape de photolithographie alignée, de préférence au premier ordre, par rapport à un élément du deuxième ensemble 6, par exemple des marques d'alignement positionnées sur le deuxième substrat 200 ou dans l'empilement d'interconnexions 201. Ainsi, la position des ouvertures d'anode et de cathodes 331, 332 par rapport aux plots de connexion anode et cathode 221, 222 est précise et il est possible de réduire des dimensions horizontales de ces derniers. Les plots de connexion 221, 222, 223 ont typiquement des dimensions minimales dans un plan parallèle au plan (X, Y) comprises entre 500 nm et 5 µm, par exemple comprises entre 500 nm et 1 µm.

Dans l'exemple de la figure 2B, des ouvertures supplémentaires 333 optionnelles sont gravées dans le masque dur 320 à l'aplomb d'un plot de connexion supplémentaire 223 respectif.

L'ouverture de cathode 332 peut avoir une forme de boucle dans un plan parallèle au plan (X, Y), par exemple une boucle circulaire, ou rectangle, ou carrée. L'ouverture d'anode 331 et les ouvertures supplémentaires 333 ont par exemple des formes de disque dans un plan parallèle au plan (X, Y). Lorsque l'ouverture de cathode 332 a une forme de boucle, celle-ci entoure l'ouverture d'anode 331. Ici, l'ouverture de cathode 332 a une forme de boucle, par exemple carrée.

Les ouvertures sont par exemple réalisées par une gravure sèche réactive au travers d'une résine insolée lors de la sous-étape de photolithographie, avec arrêt sur la couche dopée de type n 101.2. La résine peut être retirée par application d'un plasma d'oxygène et d'un solvant chimique.

En figure 2C, l'empilement actif 301, la couche conductrice inférieure 102, la couche de collage 303 et la couche de passivation optionnelle sont successivement gravés au travers des ouvertures d'anode, de cathode et supplémentaires 331, 332, 333, jusqu'à atteindre les plots de connexion 221, 222, 223. Une ou plusieurs sous-étapes de gravures sèches réactives sont par exemple utilisée. La dernière sous-étape de gravure est par exemple une gravure sélective de la couche de passivation ou de la couche de collage 303, par rapport au matériau métallique des plots de connexion 221, 222, 223. Un nettoyage chimique peut avantageusement être pratiqué après l'étape de gravure.

A l'issue de l'étape de la figure 2C, il est obtenu un premier trou d'anode 341 au regard de l'ouverture d'anode 331, une tranchée de cathode 342 au regard de l'ouverture de cathode 332 et des trous supplémentaires 343 au regard des ouvertures supplémentaires 333. Le premier trou d'anode 341 a un fond consistant en une partie du plot de connexion anode 221. De même, la tranchée de cathode 342 et les trous supplémentaires 343 ont chacun un fond consistant respectivement, en une partie du plot de connexion cathode 222 et des plots de connexion supplémentaires 223. Avantageusement, le plot de connexion anode 221, le plot de connexion cathode 222 et les plots de connexion supplémentaires 223 ont des formes similaires, respectivement, au premier trou d'anode 341, à la tranchée de cathode 342 et aux trous supplémentaires 343 dans un plan parallèle au plan (X, Y), avec éventuellement une différence de dimensionnement dans ce plan pouvant absorber des erreurs d'alignement lors de la sous-étape de photolithographie. Le premier trou d'anode 341, la tranchée de cathode 342 et les trous supplémentaires 343 sont ci-après appelés collectivement tranchées traversantes 341, 342, 343.

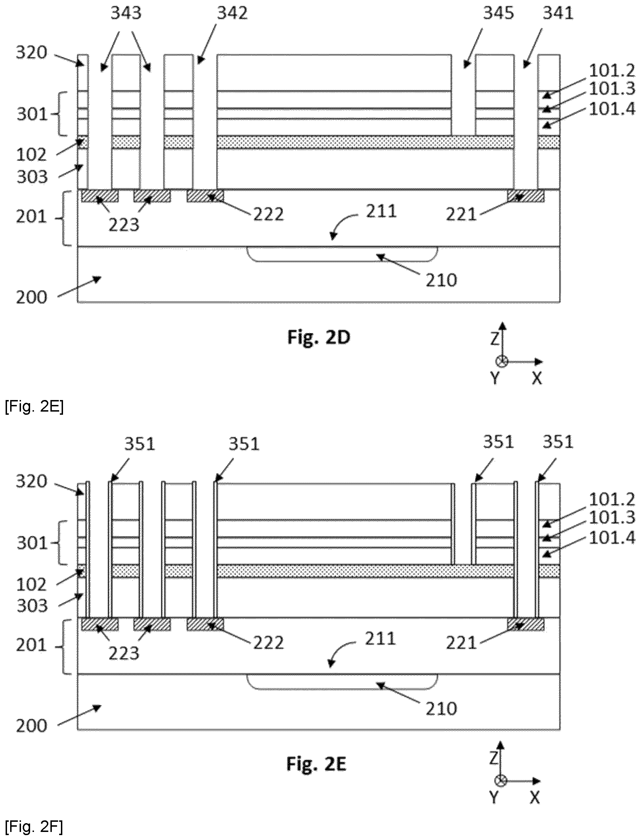

En figure 2D, une ouverture additionnelle est gravée dans le masque dur 320. Un deuxième trou d'anode 345 est ensuite gravé dans l'empilement actif 301 au travers de l'ouverture additionnelle, jusqu'à atteindre la couche conductrice inférieure 102, sans la dépasser. L'ouverture additionnelle est par exemple définie par une sous-étape de photolithographie alignée, de préférence au premier ordre, sur un élément du deuxième ensemble 6, par exemple des marques d'alignement positionnées sur le deuxième substrat 200 ou dans l'empilement d'interconnexions 201. Lorsque l'empilement actif 301 est à base de nitrure de gallium et la couche conductrice inférieure 102 en oxyde d'indium-étain (ITO), le deuxième trou d'anode 345 peut être gravé par un plasma de BCI₃, sélectivement par rapport à l'oxyde d'indium-étain (ITO). Ainsi, il est plus aisé d'arrêter la gravure du deuxième trou d'anode 345 sur la couche conductrice inférieure 102. La couche conductrice inférieure 102 a préférentiellement une épaisseur supérieure ou égale à 100 nm pour absorber une variation subie d'épaisseur de l'empilement actif 301, typiquement inférieure ou égale à 300 nm.

En figure 2E, une couche de passivation est déposée de façon conforme directement sur le masque dur 320, et sur des flancs et les fonds respectifs des tranchées traversantes 341, 342, 343 et du deuxième trou d'anode 345. La couche de passivation a sensiblement la même épaisseur sur une face supérieure du masque dur 320, sur des flancs et les fonds respectifs des tranchées traversantes 341, 342, 343 et du deuxième trou d'anode 345. La variation d'épaisseur de la couche de passivation est par exemple inférieure ou égale à 10 %, préférentiellement inférieure à 5 %. Avantageusement, le dépôt de la couche de passivation peut être précédé d'un nettoyage chimique, par exemple à base de TMAH et/ou KOH.

Dans toute section parallèle au plan (X, Y) au niveau des flancs des tranchées traversantes 341, 342, 343 et du deuxième trou d'anode 345, l'épaisseur de la couche de passivation est telle que tout couple de flancs opposés est séparé par deux parties distinctes de la couche de passivation. La couche de passivation peut par exemple être en alumine (Al₂O₃), en nitrure de silicium (SiN) ou en nitrure d'aluminium (AIN). Dans cet exemple, la couche de passivation est en alumine (Al₂O₃) et a une épaisseur comprise entre 20 nm et 100 nm.

La couche de passivation est ensuite gravée de façon anisotrope perpendiculairement au plan (X, Y), pour obtenir une couche de passivation latérale 351. La gravure peut être une gravure sèche réactive. Préférentiellement, elle peut être suivie d'un nettoyage chimique. Au cours de cette sous-étape de gravure, la partie de la couche de passivation en contact avec les plots de connexion anode, cathode 221, 222 et les plots de connexion supplémentaires 223 est entièrement retirée. De même, la partie de la couche de passivation en contact avec la couche conductrice inférieure 102 est entièrement retirée. De préférence, la couche de passivation est entièrement retirée sur la face supérieure du masque dur 320.

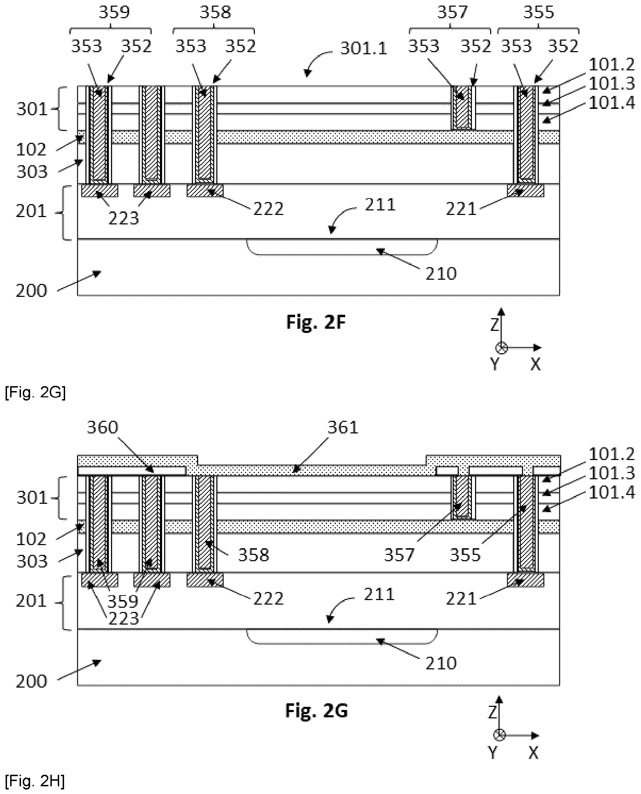

En figure 2F, une couche fine est déposée de façon conforme sur la face supérieure du masque dur 320, sur la couche de passivation latérale 351 et sur des flancs et les fonds respectifs des tranchées traversantes 341, 342, 343 et du deuxième trou d'anode 345. Dans toute section parallèle au plan (X, Y) au niveau des flancs des tranchées traversantes 341, 342, 343 et du deuxième trou d'anode 345, les épaisseurs de la couche de passivation et de la couche fine sont telles que tout couple de flancs opposés est séparé par deux parties distinctes de la couche fine. La couche fine est en contact avec les plots de connexion 221, 222, 223 et la couche conductrice inférieure 102. La couche fine est apte à conduire l'électricité.

Ensuite, on remplit, de préférence intégralement, les volumes définis par la couche fine à l'intérieur des tranchées traversantes 341, 342, 343 et du deuxième trou d'anode 345 d'un matériau métallique. Cette étape peut par exemple comprendre une sous-étape de dépôt conforme d'une couche germe conductrice, suivie par une croissance d'un matériau métallique par dépôt électrochimique (Electrochemical Déposition ou ECD, en anglais). Le matériau métallique peut être du cuivre (Cu). La couche de germe peut consister en une sous-couche de nitrure de titane (TiN) intercalée entre une sous-couche en titane (Ti) et une sous-couche en cuivre (Cu). La sous-couche en Ti est en contact avec la sous-couche fine et avec la sous-couche en TiN. La sous-couche en Cu est en contact avec la couche en TiN.

On retire ensuite la partie de la couche fine en contact avec le masque dur 320, la partie de la couche de passivation latérale 351 en contact avec le masque dur, la partie excédentaire du matériau métallique située sur une partie supérieure s'étendant verticalement depuis une face supérieure 301.1 de l'empilement actif 301, et le masque dur 320 lui-même. Il en résulte que la couche dopée de type n 101.2 est mise à nue.

A l'issue de cette sous-étape de retrait, une partie résiduelle de la couche fine, une partie résiduelle de la couche de passivation latérale 351 et une partie résiduelle du matériau métallique affleurent la face supérieure 301.1 de l'empilement actif 301. Cette sous-étape de retrait peut comprendre une ou plusieurs étapes de polissage mécano-chimique et éventuellement, une ou plusieurs étapes de nettoyage. La sous-étape de remplissage du matériau métallique, suivie de cette sous-étape de retrait peuvent comprendre une ou plusieurs briques usuelles d'un procédé damascène.

Avantageusement, la couche fine est apte à réfléchir un flux lumineux à la longueur d'onde d'émission λ₁ et/ou à la longueur d'onde de détection λ₂. La couche fine peut être par exemple en aluminium (AI), en alliage d'aluminium-silicium (AISi), ou en cuivre (Cu). L'épaisseur de la couche fine est par exemple égale à 80 nm au niveau des flancs des tranchées traversantes 341, 342, 343 et du deuxième trou d'anode 345, et égale à 300 nm sur la face supérieure du masque dur 320.

A l'issue de l'étape de la figure 2F, la partie résiduelle de la couche fine constitue un revêtement 352. Les parties résiduelles du matériau métallique à l'intérieur des tranchées traversantes 341, 342, 343 et du deuxième trou d'anode 345 constituent chacune un remplissage métallique 353. Chaque remplissage métallique 353 en association avec une partie du revêtement 352 d'une tranchée traversante 341, 342, 343 correspondante constitue un via 355, 359 ou une tranchée 358 conducteurs de l'électricité en contact physique avec un plot parmi les plots de connexion 221, 222, 223. Ainsi un via d'anode 355, une tranchée conductrice 358 et des via supplémentaires 359 sont logés respectivement dans le premier trou d'anode 341, la tranchée de cathode 342 et les trous supplémentaires 343. Le remplissage métallique 353 en association avec la partie du revêtement 352 d'une tranchée traversante 341, 342, 343 correspondante constitue un contact d'anode 357 conducteur de l'électricité en contact physique avec la couche conductrice inférieure 102.

Lorsque la couche fine est réfléchissante, les parties du revêtement 352 en regard des flancs des tranchées traversantes 341, 342, 343 et du deuxième trou d'anode 345 constituent chacune un miroir.

En figure 2G, on forme une couche de passivation supérieure 360 sur la face supérieure 301.1 de l'empilement actif 301. La couche de passivation supérieure 360 comporte des ouvertures la traversant de part en part. Une première ouverture est disposée en regard de la surface de détection 211 et en regard de la tranchée conductrice 358, une deuxième ouverture est disposée en regard du contact d'anode 357 et une troisième ouverture est disposée en regard du via d'anode 355. De préférence, la première ouverture recouvre la totalité de la surface de détection 211. Avantageusement, la première ouverture recouvre la totalité de la tranchée conductrice 358. La couche de passivation supérieure 360 peut par exemple être en nitrure de silicium (SiN) et avoir une épaisseur comprise entre 50 nm et 100 nm. Les première, deuxième et troisième ouvertures et des éventuelles ouvertures supplémentaires traversant de part en part la couche de passivation supérieure 360 sont collectivement appelées ci-après les ouvertures supérieures.

Ensuite, on dépose une couche conductrice supérieure 361 sur la couche de passivation supérieure 360 et sur une partie de la couche dopée de type n 101.2 exposée dans les ouvertures supérieures. La couche conductrice supérieure 361 est ici continue et en contact physique avec la couche dopée de type n 101.2, le contact d'anode 357 et le via d'anode 355. Elle est transparente à la longueur d'onde d'émission λ₁ et à la longueur d'onde de détection λ₂. Elle transmet par exemple au moins 50 % d'une lumière incidente en incidence normale à la longueur d'onde d'émission λ₁ et de détection λ₂, ou préférentiellement au moins 90 %, voire au moins 95 %. La couche conductrice supérieure 361 peut être en un oxyde métallique, par exemple en oxyde d'indium-étain (ITO), en oxyde de zinc dopé à l'aluminium (AZO) ou en dioxyde d'étain (SnO2). Dans cet exemple, la couche conductrice supérieure 361 est en oxyde d'indium-étain (ITO) et a une épaisseur comprise entre 60 nm et 120 nm. Une épaisseur comprise entre 100 nm et 120 nm permet d'obtenir une transmission satisfaisante et une bonne conductivité électrique.

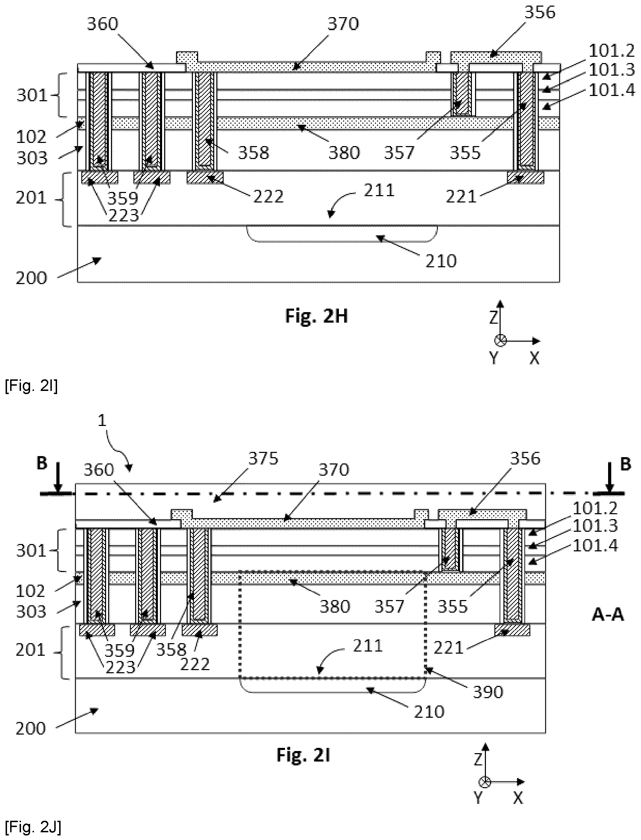

En figure 2H, on isole par gravure une portion de la couche conductrice supérieure 361 en contact avec le contact d'anode 357 et le via d'anode 355 pour réaliser une ligne conductrice 356. La ligne conductrice 356 est isolée électriquement de la couche dopée de type n 101.2 par la couche de passivation supérieure 360. La couche conductrice supérieure 361 est gravée sur toute son épaisseur, préférentiellement au niveau de zones reposant intégralement sur la couche de passivation supérieure 360.

Une partie restante de la couche conductrice supérieure 361 en contact avec la couche dopée de type n 101.2 dans la première ouverture constitue une électrode surfacique 370 d'une diode électroluminescente, qui est ici une électrode de cathode 370 de la diode électroluminescente. L'électrode de cathode 370 se prolonge par une partie de la couche conductrice supérieure 361 en contact avec la tranchée conductrice 358, préférentiellement avec toute une face supérieure de la tranchée conductrice 358 affleurant la face supérieure 301.1 de l'empilement actif 301. Préférentiellement, l'électrode de cathode 370 recouvre l'intégralité d'une surface de la couche dopée de type n 101.2 exposée dans la première ouverture. La partie de la couche conductrice inférieure 102 en contact physique avec le contact d'anode 357 constitue une électrode enterrée 380 de la diode électroluminescente, qui est ici une électrode d'anode 380 de la diode électroluminescente. Une partie de l'électrode de cathode 370, préférentiellement toute l'électrode de cathode 370, est à l'aplomb de l'électrode d'anode 380.

Les étapes des figures 2B à 2H conduisent à la formation d'une région active de la diode électroluminescente, agencée dans la couche active 101.3. Des géométries et les positions relatives de l'électrode de cathode 370 et de l'électrode d'anode 380 délimitent des dimensions horizontales de la région active. Ici, l'électrode d'anode 380 et l'électrode de cathode 370 sont délimitées par la tranchée conductrice 358. Il en est par conséquent de même de la région active. Ainsi, la formation de la tranchée conductrice 358 participe à la formation de la région active. La tranchée conductrice 358 étant alignée, de préférence au premier ordre, par rapport à un élément du deuxième ensemble 6, le positionnement de la région active par rapport à la surface de détection 211 est précis. Il en est de même des positionnements du via d'anode 355 et du contact d'anode 357 par rapport à la surface de détection 211 et à l'empilement d'interconnexions 201.

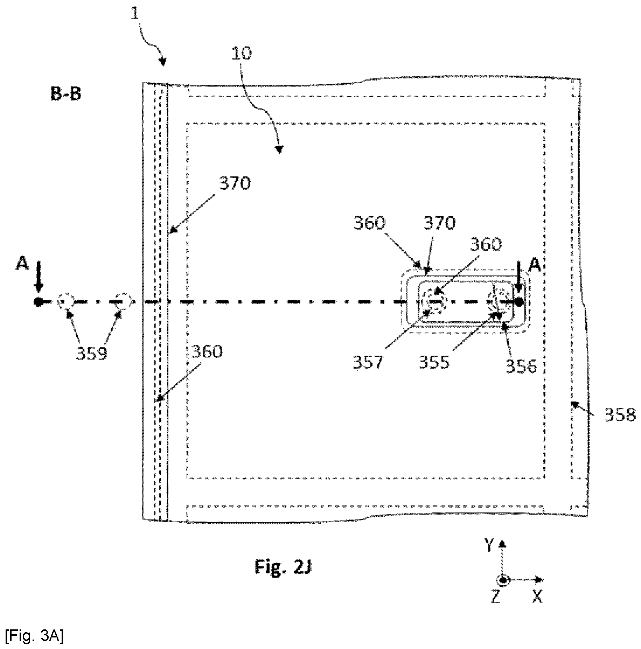

Les figures 2I et 2J illustrent une étape finale du premier procédé de fabrication. Ce sont des vues du premier mode de réalisation d'un premier dispositif optoélectronique 1 selon l'invention. La figure 2J est une vue en coupe de dessus selon le plan de coupe B-B de la figure 2I. La figure 2I est une vue en coupe transversale selon le plan de coupe A-A de la figure 2J.

Lors de l'étape finale, une couche d'encapsulation 375 optionnelle est déposée sur la couche de passivation supérieure 360, l'électrode de cathode 370 et la ligne conductrice 356. La couche d'encapsulation 375 peut comprendre une ou plusieurs sous-couches, par exemple en un matériau choisi parmi de l'oxyde de silicium (SiO) ou du nitrure de silicium

(SiN). La couche d'encapsulation 375 peut avoir une face supérieure plane sur une partie opposée au deuxième substrat 200. L'étape finale peut comprendre une sous-étape postérieure au dépôt de la couche d'encapsulation 375 d'amincissement du deuxième substrat 200, par exemple pour mettre à nu des via s'étendant en profondeur dans le deuxième substrat 200 depuis la face avant du deuxième substrat 200.

Le premier dispositif optoélectronique 1 comporte un pixel 10. Dans le cas particulier des figures 2I et 2J, le premier dispositif optoélectronique 1 comprend plusieurs pixels 10 identiques agencés en matrice. La matrice s'étend dans un plan parallèle au plan (X, Y). Seul un pixel 10 est représenté sur la figure 2J. Celui est positionné sur un bord de la matrice de pixels.

Le pixel 10 comporte un photodétecteur 210, une diode électroluminescente et une région intermédiaire 390 intercalée entre le photodétecteur 210 et la diode électroluminescente. Le photodétecteur 210 est ici une photodiode, par exemple une photodiode épinglée (ou pinned photodiode, en anglais). Une surface supérieure d'une région dopée de la photodiode délimite la surface de détection 211.

La diode électroluminescente comprend l'électrode d'anode 380 et une partie de l'empilement actif 301 délimitée par la tranchée de cathode 342. L'électrode d'anode 380 est également délimitée par la tranchée de cathode 342. La diode électroluminescente comporte en outre l'électrode de cathode 370. Cette dernière est délimitée par la tranchée de cathode 342 dans le plan de la face supérieure 301.1 de l'empilement actif 301.

La région intermédiaire 390 est une région fictive qui s'étend depuis la surface de détection 211 jusqu'à l'empilement actif 301. Elle a une base et une paroi. La base est la surface de détection 211, ici placée au voisinage de la face avant du deuxième substrat 200. La paroi est parallèle à l'axe Z. Il peut s'agir d'un prisme droit ou d'un cylindre elliptique droit. La région intermédiaire 390 comporte une partie traversante de l'empilement d'interconnexions 201, une partie traversante de la couche de collage 303 et une partie traversante de l'électrode d'anode 380. Elle est dépourvue d'éléments métalliques.

Le premier dispositif optoélectronique 1 comprend un chemin électrique connectant électriquement l'électrode d'anode 380 au circuit de contrôle. Le chemin électrique comporte le contact d'anode 357, le via d'anode 355 et la ligne conductrice 356. La ligne conductrice 356 est séparée de l'électrode de cathode 370 par un matériau isolant qui peut être de l'air, ou, comme représenté ici, une partie de la couche d'encapsulation 375. La ligne conductrice 356 a ici une forme sensiblement rectangulaire en vue de dessus. Dans cet exemple, l'électrode de cathode 370 entoure la ligne conductrice 356 dans toutes les directions d'un plan parallèle au plan (X, Y). Alternativement, la ligne conductrice 356 peut s'étendre au-dessus de la tranchée de cathode 342, sur une partie isolée de la tranchée conductrice 358 par la couche de passivation supérieure 360. Dans ce cas, elle peut connecter électriquement un contact d'anode 357 d'un pixel 10 voisin. Préférentiellement, le circuit de contrôle a des composants ou des lignes de connexion agencés sous le plot de connexion anode 221, et/ou sous le contact d'anode 357, et/ou sous la ligne conductrice 356. Les composants peuvent par exemple être des transistors ou des régions dopées.

Les tranchées conductrices 358 de deux pixels 10 voisins peuvent être distinctes. Alternativement, comme dans cet exemple particulier, les tranchées conductrices 358 de deux pixels 10 voisins ont une partie en commun. Ici, les tranchée conductrice 358 de la matrice de pixels 10 forment, en vue de dessus, un quadrillage de lignes orthogonales, délimité par des lignes externes formant un cadre rectangulaire ou carré. Chaque partie entre deux intersections voisines du quadrillage constitue la partie commune des tranchées conductrices 358.

L'électrode de cathode 370 d'un pixel peut être isolée électriquement de l'électrode de cathode 370 d'un ou plusieurs pixels voisins. Alternativement, comme représenté en figure 2J, plusieurs pixels 10, préférentiellement tous les pixel 10, ont une électrode de cathode 370 commune, c'est-à-dire que l'électrode de cathode 370 d'un pixel 10 est reliée électriquement aux électrodes de cathode 370 d'autres pixels 10, préférentiellement tous les pixel 10, de la matrice par des portions de la couche conductrice supérieure 361.

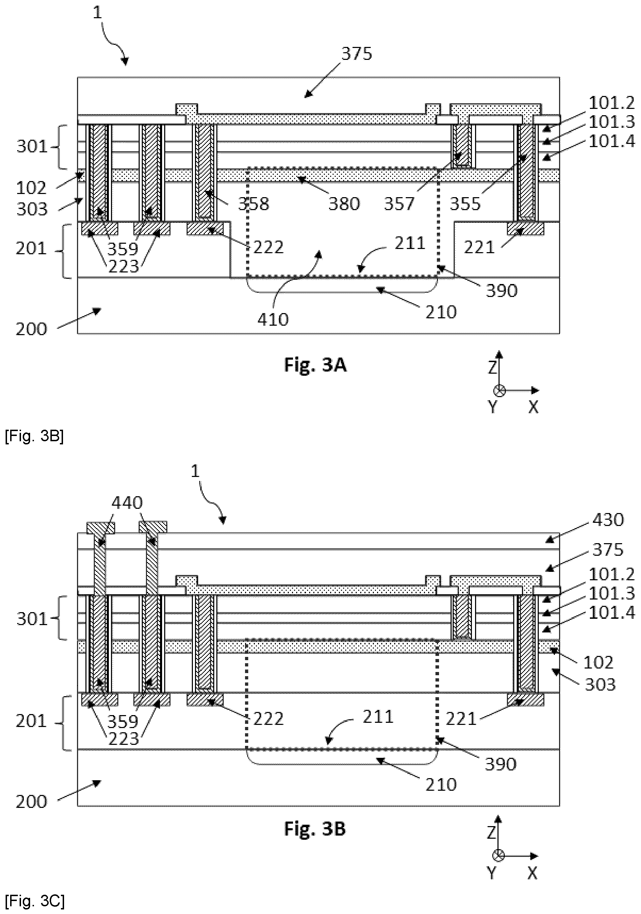

A présent des variantes du premier mode de réalisation vont être décrites en lien avec les figures 3A à 3E. Seules les différences par rapport au premier mode de réalisation sont explicitement décrites. Ces variantes comportent des caractéristiques additionnelles par rapport au premier mode de réalisation qui peuvent être toutes combinées entre-elles pour donner lieu à des variantes supplémentaires rentrant dans le cadre de l'invention.

La figure 3A décrit une première variante utile, par exemple, lorsque la région de l'empilement d'interconnexions 201 en regard de la surface de détection 211 comprend des sous-couches non métalliques absorbantes ou réfléchissantes à la longueur d'onde d'émission λ₁ et/ou à la longueur d'onde de détection λ₂, par exemple une ou des sous-couches en nitrure de silicium (SiN). Dans cette variante, préalablement à l'étape de report de la figure 2A, on a gravé un évidement 410 dans l'empilement d'interconnexions 201 en regard de la surface de détection 211 pour retirer des parties de sous-couches absorbantes. L'évidement 410 a des dimensions suffisantes pour supprimer toutes les parties des sous-couches absorbantes à l'aplomb de la surface de détection 211. Préférentiellement, comme cela est représenté ici, l'évidement 410 traverse de part en part l'empilement d'interconnexions 201. Avantageusement, l'intégralité de la surface de détection 211 est en regard de l'évidement 410.

La couche de collage inférieure 203 est une couche déposée postérieurement à la gravure de l'évidement 410, remplissant entièrement l'évidement 410. Il est par exemple possible de déposer une couche diélectrique, par exemple un oxyde de silicium (SiO) d'une épaisseur strictement supérieure à une profondeur selon la direction Z de l'évidement 410, suivie d'un polissage, par exemple un polissage mécano-chimique (CMP).

La figure 3B décrit une deuxième variante intégrant une couche surfacique de fonction optique 430. La couche surfacique de fonction optique 430 est une couche déposée sur la couche d'encapsulation 375 à l'issue de l'étape de la figure 2l.

La couche surfacique de fonction optique 430 peut par exemple être une couche antireflet 430 configurée pour obtenir une fonction d'antireflet à la longueur d'onde d'émission λ₁ et/ou à la longueur d'onde de détection λ₂. La couche antireflet 430 peut être une couche unique ou comprendre plusieurs sous-couches. Le matériau et l'épaisseur de la couche ou les matériaux et les épaisseurs des sous-couches sont choisis, par exemple par simulation, pour obtenir la fonction d'antireflet voulue.

Par exemple, la couche antireflet 430 peut être en nitrure de silicium (SiN). Elle peut avoir une épaisseur comprise entre 50 nm et 65 nm, ou entre 175 nm et 190 nm ou entre 295 nm et 310 nm, ceci pour obtenir une fonction antireflet à une longueur d'onde d'émission λ₁ de 365 nm, pour un empilement actif 301 en nitrure de gallium (GaN), une couche conductrice supérieure 361 en oxyde d'indium-étain (ITO) de 100 nm d'épaisseur et une couche d'encapsulation 375 en oxyde de silicium (SiO). En combinaison avec une épaisseur de la couche d'encapsulation 375 inférieure à 200 nm, la transmission d'un flux lumineux émis par la diode électroluminescente depuis la face supérieure 301.1 de l'empilement actif 301 est supérieure à 90 %. Les trois plages d'épaisseur de la couche antireflet 430 en nitrure de silicium (SiN) ci-dessus en combinaison, respectivement, avec des gammes d'épaisseur de la couche d'encapsulation 375 comprises entre 100 nm et 150 nm, ou entre 140 nm et 170 nm, ou entre 50 nm et 150 nm, permettent d'obtenir en outre un taux de transmission d'un flux lumineux incident sur la couche antireflet 430 dans l'empilement actif 301 supérieur à 90 % à une longueur d'onde de détection λ₂ égale à 630 nm.

La couche surfacique de fonction optique 430 peut être une couche surfacique absorbante à la longueur d'onde d'émission λ₁. La couche surfacique absorbante a une ouverture traversante (non représentée sur la figure 3B) au regard de la région active de la diode électroluminescente et s'étend sur une surface de la couche d'encapsulation 375 en regard d'une région entre deux pixels 10 voisins. Dans cet exemple particulier, elle s'étend également sur une surface de la couche d'encapsulation 375 en regard de la ligne conductrice 356. Ainsi, un flux lumineux émis par une diode électroluminescente d'un pixel 10 guidé par la couche d'encapsulation 375 est atténué, et un phénomène de diaphonie peut être évité.

En figure 3B, des plots 440 optionnels sont représentés. Les plots 440 traversent de part en part la couche d'encapsulation 375 à l'aplomb d'un via supplémentaire 359 correspondant. Les plots 440 sont en un matériau conducteur de l'électricité. En présence d'une couche surfacique de fonction optique 430, comme représenté ici, ils peuvent la traverser de part en part ou être agencés dans une ouverture traversante pratiquée dans la couche surfacique de fonction optique 430. Les plots 440 peuvent être en nombre quelconque supérieur ou égal à 1. Lorsque le premier dispositif optoélectronique 1 comporte une matrice de pixels 10, ils peuvent être agencés dans une partie périphérique de la matrice de pixels 10. Cela peut par exemple être des plots 440 servant au test électrique du premier dispositif optoélectronique 1, par exemple avant individualisation du premier dispositif optoélectronique 1 par découpe d'un deuxième substrat 200 comportant plusieurs premiers dispositifs optoélectroniques 1.

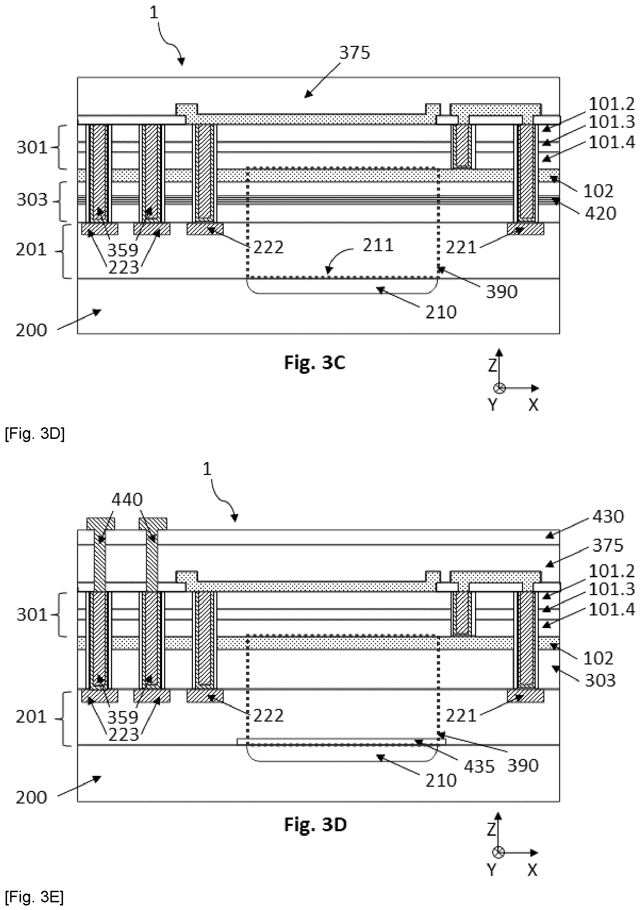

La figure 3C décrit une troisième variante intégrant une couche intermédiaire de fonction optique 420 dans la couche de collage 303. La couche intermédiaire de fonction optique 420 est une sous-couche de la couche de collage supérieure 103 ou de la couche de collage inférieure 203, ou la couche intermédiaire de fonction optique 420 peut être issue de la combinaison de sous-couches dans les couches de collage supérieure et inférieure 103, 203. La troisième variante peut être avantageuse lorsque le photodétecteur 210 est à la fois sensible à la longueur d'onde d'émission λ₁ et à la longueur d'onde de détection λ₂ et est destiné à fonctionner en même temps que la diode électroluminescente. Le photodétecteur 210 n'est ainsi pas ébloui par la diode électroluminescente.

La surface de détection 211 d'au moins un pixel 10, préférentiellement tous les pixels 10, est intégralement en regard de la couche intermédiaire de fonction optique 420, c'est-à-dire que la région intermédiaire 390 comprend une partie au moins de la couche intermédiaire de fonction optique 420. Lorsque la couche intermédiaire de fonction optique 420 est intégrée à la couche de collage inférieure 203, il est possible de graver des ouvertures traversant la couche intermédiaire de fonction optique 420 à l'aplomb de la surface de détection 211 de certains pixels 10.

La couche intermédiaire de fonction optique 420 peut être un filtre interférentiel. Le filtre interférentiel peut par exemple être configuré pour augmenter un ratio d'une transmission d'un flux lumineux à la longueur d'onde de détection λ₂ sur une transmission d'un flux lumineux à la longueur d'onde d'émission λ₁. Pour une longueur d'onde d'émission λ₁ comprise dans la gamme des UVA et une longueur d'onde de détection λ₂ comprise dans le spectre visible, la couche intermédiaire de fonction optique 420 peut comprendre une alternance de sous-couches en nitrure de silicium (SiN) et en oxyde de silicium (SiO), par exemple 9 bicouches SiN/SiO, l'épaisseur des sous-couches en nitrure de silicium (SiN) peuvent par exemple être égales à 44 nm et l'épaisseur des sous-couches en oxyde de silicium (SiO) peuvent par exemple être égales à 62 nm.

La couche intermédiaire de fonction optique 420 peut être une couche réfléchissante. La couche réfléchissante peut par exemple être une lame quart d'onde indépendante de la polarisation de la lumière, par exemple à la longueur d'onde d'émission λ₁ . Ainsi, un ratio de la transmission d'un flux lumineux à la longueur d'onde de détection λ₂ sur la transmission d'un flux lumineux à la longueur d'onde d'émission λ₁ est augmenté. La lame quart d'onde peut être en silicium amorphe. Le cas échéant, la lame quart d'onde peut résulter de l'assemblage de couches de collage supérieure et inférieure 103, 203 comprenant du silicium amorphe sur leurs faces à assembler lors d'un collage par diffusion atomique (« Atomic diffusion bonding » ou ADB, en anglais). La lame quart d'onde en silicium amorphe peut par exemple avoir une épaisseur égale à 19,2 nm.

La couche intermédiaire de fonction optique 420 peut être une couche absorbante, par exemple en silicium amorphe d'une épaisseur de 100 nm.

La figure 3D décrit une quatrième variante reprenant les caractéristiques de la variante de la figure 3B et intégrant en outre une fenêtre antireflet 435 agencée en regard de la surface de détection 211. La région intermédiaire 390 comprend la fenêtre antireflet 435. La fenêtre antireflet 435 est par exemple en contact avec la face avant du deuxième substrat 200. Elle a une couche de fonction optique qui a une fonction d'antireflet à la longueur d'onde de détection λ₂. Il peut s'agir par exemple d'une couche structurée en oxyde de tantale (Ta₂O₅), en alumine (Al₂O₃), en nitrure de silicium (SiN) ou en oxyde de titane (TiO₂). Pour une longueur d'onde de détection λ₂ égale à 630 nm, une photodiode en silicium (Si) passivée par une couche d'alumine (Al2O3) de 15 nm d'épaisseur intercalée entre la fenêtre antireflet 435 et la photodiode et en contact avec celles-ci, la fenêtre antireflet 435 peut par exemple être en oxyde de tantale (Ta2O5) et avoir une épaisseur supérieure à 70 nm, par exemple égale à 105 nm. Elle peut également être en nitrure de silicium (SiN) et avoir une épaisseur comprise entre 410 nm et 430 nm.

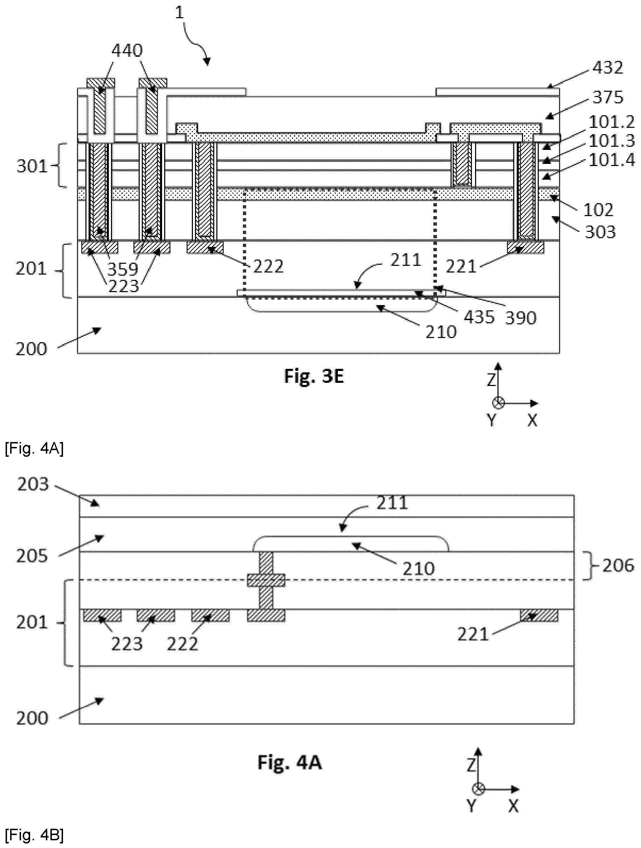

La figure 3E décrit une cinquième variante intégrant la fenêtre antireflet 435 introduite à la figure 3D et un élément chauffant 432. La fenêtre antireflet 435 est ici optionnelle.

Pour cette variante, à l'issue de l'étape de la figure 2l, une ouverture traversante est gravée au travers de la couche d'encapsulation 375 au regard d'un via supplémentaire 359. Une couche conductrice supplémentaire en un matériau conducteur de l'électricité est ensuite déposée de façon conforme dans un fond et sur un flanc de l'ouverture et sur la face supérieure de la couche d'encapsulation 375. La couche conductrice supplémentaire est en contact avec le via supplémentaires 359 et s'étend continûment depuis le via supplémentaire 359 vers la face supérieure de la couche d'encapsulation 375. Elle est ensuite gravée sur toute son épaisseur au regard de la région active de la diode électroluminescente pour obtenir l'élément chauffant 432.

L'élément chauffant 432 a une ouverture traversante au regard de la région active de la diode électroluminescente et, préférentiellement, s'étend sur une surface de la couche d'encapsulation 375 en regard d'une région entre deux pixels 10 voisins. Dans cet exemple particulier, il s'étend également sur une surface de la couche d'encapsulation 375 en regard de la ligne conductrice 356.

L'élément chauffant 432 est apte à s'échauffer par effet Joule lorsqu'il est traversé par un courant électrique passant par le via supplémentaire 359. Le courant électrique peut être contrôlé par le circuit de contrôle, par exemple pour stabiliser une température surfacique du premier dispositif optoélectronique 1 ou pour effectuer un cycle thermique. Il est par exemple apte à s'échauffer à une température de 55 °C. L'élément chauffant 432 peut en outre assurer la fonction de la couche surfacique absorbante de la figure 3B.

La couche conductrice supplémentaire peut par exemple être en nitrure de titane (TiN), permettant ainsi d'assurer à la fois la fonction de chauffage par effet Joule et la réduction de la diaphonie. Elle peut par exemple avoir une épaisseur de 100 nm.

Optionnellement, l'élément chauffant 432 peut être connecté électriquement à un plot 440 par une partie de la couche conductrice supplémentaire prolongeant l'élément chauffant dans une ouverture gravée dans la couche d'encapsulation 375 et la couche de passivation supérieure 360, comme cela est représenté en figure 3E.

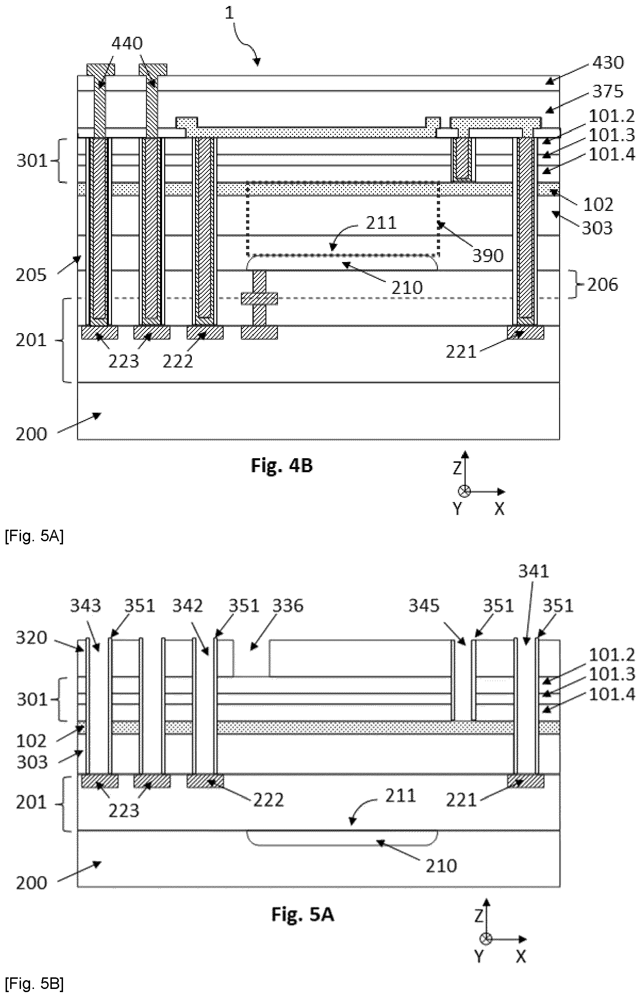

A présent, une variante du premier procédé conduisant à une sixième variante du premier dispositif optoélectronique 1 va être décrite en lien avec les figures 4A et 4B. Seules les différences par rapport au premier procédé et au premier dispositif sont explicitées. La variante du premier dispositif optoélectronique 1 illustré en figure 4B reprend ici les caractéristiques additionnelles et optionnelles de la deuxième variante de la figure 3B. Il est possible de les combiner avec une ou plusieurs caractéristiques parmi toutes les caractéristiques décrites en lien avec les autres variantes.

L'étape de report de la figure 2A est effectué avec le deuxième ensemble 6 de la figure 4A. Le photodétecteur 210 est ici intégré au moins en partie dans et/ou sur un troisième substrat 205. Le troisième substrat 205 comporte un empilement d'interconnexions supplémentaire 206 en contact avec une face avant du troisième substrat 205. Le photodétecteur 210 est ici une photodiode affleurant la face avant du troisième substrat 205. Le troisième substrat 205 est reporté sur l'empilement d'interconnexions 201, par exemple par collage hybride métal-oxyde de l'empilement d'interconnexions supplémentaire 206 sur l'empilement d'interconnexions 201, comme cela est représenté ici. La région intermédiaire 390 s'étend depuis la photodiode jusqu'à l'empilement actif 301 et comprend une partie du troisième substrat 205, une partie de la couche de collage 303 et une partie de la couche conductrice inférieure 102. Elle a une base et une paroi. La base est la surface de détection 211, ici placée dans le troisième substrat 205. La paroi est parallèle à l'axe Z. Il peut s'agir d'un prisme droit ou d'un cylindre elliptique droit. La région intermédiaire 390 est dépourvue de métal.

Le troisième substrat 205 a préférentiellement des dimensions identiques aux dimensions du deuxième substrat 200 dans un plan parallèle au plan (X, Y). Il peut être en un matériau identique ou différent du matériau du deuxième substrat 200. Le matériau du troisième substrat 205 peut par exemple être du silicium (Si), du germanium (Ge), ou un arséniure de gallium-indium (InGaAs).

A l'étape de la figure 2B, la formation de l'ouverture d'anode 331 et de l'ouverture de cathode 332 peut comprendre une sous-étape de photolithographie alignée, de préférence au premier ordre, sur un élément du deuxième ensemble 6, par exemple des marques d'alignement agencées sur la face avant du deuxième substrat 200, dans l'empilement d'interconnexions 201, dans l'empilement d'interconnexions supplémentaire 206 ou sur la face avant du troisième substrat 205.

A l'étape de la figure 2C, les tranchées traversantes 341, 342, 343 se prolongent au travers du troisième substrat 205 et de l'empilement d'interconnexions supplémentaire 206, jusqu'aux plots de connexion 221, 222, 223.

A présent, un deuxième procédé de fabrication conduisant à un deuxième dispositif optoélectronique 2 va être décrit en lien avec les figures 5A à 5D. Seules les différences par rapport au premier procédé et au premier dispositif sont décrites. Il est possible de combiner une ou plusieurs caractéristiques parmi toutes les caractéristiques décrites en lien avec les variantes du premier dispositif optoélectronique 1 avec ce mode de réalisation.

Pour ce deuxième procédé, on effectue tout d'abord les étapes des figures 2A à 2E du premier procédé.

En figure 5A, on grave une ouverture de cathode supplémentaire 336 dans le masque dur 320. L'ouverture de cathode supplémentaire 336 traverse de part en part le masque dur 320 et expose une partie supérieure de la couche dopée de type n 101.2. L'ouverture de cathode supplémentaire 336 est agencée par rapport au deuxième trou d'anode 345 de telle sorte qu'une ligne imaginaire allant de l'une à l'autre a une partie en regard de la surface de détection 211. Lorsque la tranchée de cathode 342 a une forme de boucle dans un plan parallèle au plan (X, Y), l'ouverture de cathode supplémentaire 336 est agencée dans une région entourée par la tranchée de cathode 342, comme c'est le cas ici. Indépendamment de la forme de la tranchée de cathode 342, l'ouverture de cathode supplémentaire 336 peut avoir une forme de boucle dans un plan parallèle au plan (X, Y), comme dans cet exemple. Le cas échéant, elle peut par exemple avoir, dans le plan, une forme elliptique, circulaire, rectangulaire, ou, comme ici, carrée. Dans le cas d'une couche dopée de type n 101.2 en nitrure de gallium (GaN), une forme en boucle de l'ouverture de cathode supplémentaire 336 est avantageuse pour un pixel 10 de grande taille, par exemple de taille supérieure à 50 µm, voire 100 µm.

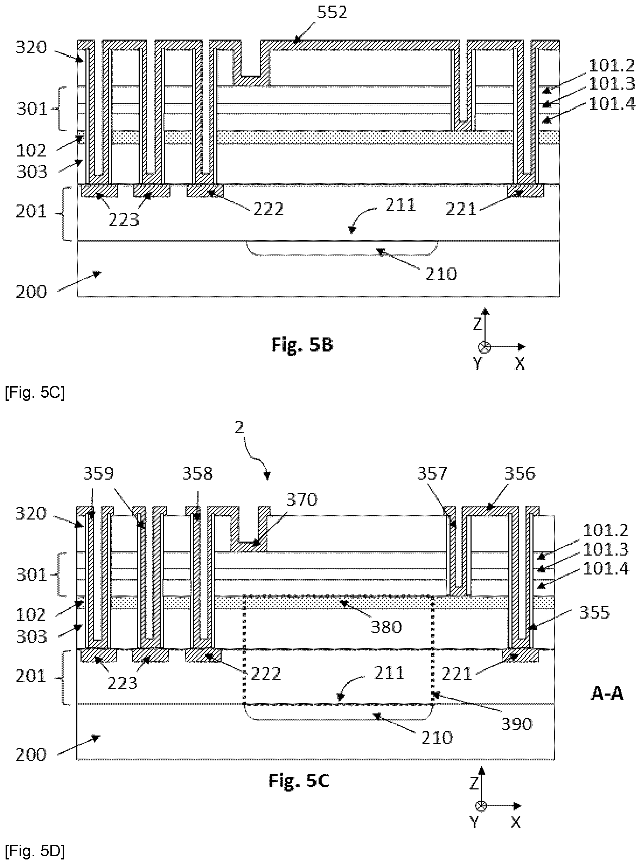

En figure 5B, on dépose de façon conforme une couche conductrice 552 sur une face supérieure du masque dur 320, sur la couche de passivation latérale 351, sur les fonds des tranchées traversantes 341, 342, 343, en contact avec les plots de connexion 221, 222, 223, et dans l'ouverture de cathode supplémentaire 336, en contact avec la couche dopée de type n 101.2. La couche conductrice 552 est apte à conduire l'électricité. Avantageusement, elle est en un métal. Préférentiellement, elle est réfléchissante à la longueur d'onde d'émission λ₁ et/ou à la longueur d'onde de détection λ₂.

La couche conductrice 552 peut être en aluminium (AI), en alliage d'aluminium-silicium (AISi), en alliage d'aluminium-cuivre (AICu), en tungstène (W) ou en titane (Ti).

En figure 5C, on grave la couche conductrice 552 de part en part pour isoler une ligne conductrice 356, en contact avec la face supérieure du masque dur 320, d'une électrode surfacique 370, en contact avec la partie exposée de la couche dopée de type n 101.2. L'électrode surfacique est ici une électrode de cathode 370. La ligne conductrice 356 et l'électrode de cathode 370 sont deux parties distinctes de la couche conductrice 552 isolées par la gravure. L'électrode de cathode 370 est par définition restreinte à la partie de la couche conductrice 552 en contact avec la couche dopée de type n 101.2 dans l'ouverture de cathode supplémentaire 336. A l'issue de cette étape, la ligne conductrice 356 se prolonge en un contact d'anode 357 consistant en une partie de la couche conductrice 552 en contact avec la couche conductrice inférieure 102, agencée dans le deuxième trou d'anode 345. Elle se prolonge également en un via d'anode 355 consistant en une partie de la couche conductrice 552 en contact avec le plot de connexion anode 221, agencée dans le premier trou d'anode 341. L'électrode de cathode 370 se prolonge en une tranchée conductrice 358 consistant en une partie de la couche conductrice 552 en contact avec le plot de connexion cathode 222, agencée dans la tranchée de cathode 342. La ligne conductrice 356, le contact d'anode 357 et le via d'anode 355 constituent ensemble un chemin électrique connectant électriquement le circuit de contrôle à l'électrode d'anode 380. Le chemin électrique est isolé électriquement de l'empilement actif 301 par le masque dur 320 et la couche de passivation latérale 351.

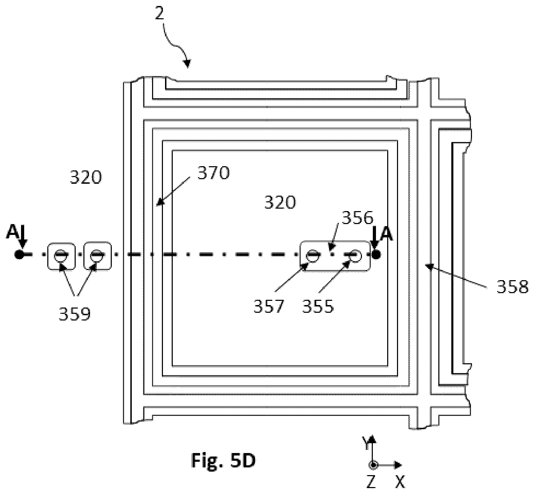

La ligne conductrice 356 a ici une forme sensiblement rectangulaire en vue de dessus (figure 5D). Toujours dans cet exemple, elle est entourée par l'électrode de cathode 370 qui est elle-même entourée par la tranchée conductrice 358.

Dans le cas où le deuxième dispositif optoélectronique 2 comporte des plots 440, ceux-ci peuvent reposer sur des parties de la couche conductrice 552 reposant sur la face supérieure du masque dur 320, isolées électriquement de la ligne conductrice 356, de l'électrode de cathode 370, du via d'anode 355, du contact d'anode 357 et de la tranchée conductrice 358 par la gravure. La couche d'encapsulation 375 peut remplir des volumes vides dans les tranchées traversantes 341, 342, 343, l'ouverture de cathode supplémentaire 336 et le deuxième trou d'anode 345, le cas échéant.

Des modes de réalisation particuliers viennent d'être décrits. Différentes variantes et modifications apparaîtront à la personne du métier. Il est par exemple à la portée de la personne du métier d'utiliser une couche de colle organique 303 lors du report du premier ensemble 5 sur le deuxième ensemble 6, par exemple une couche de silicone ou une couche de polyimide.

## Revendications

1. Dispositif optoélectronique (1, 2), comportant :
∘ un substrat (200) ;
∘ un circuit de contrôle intégré dans et/ou sur le substrat (200) comportant un empilement d'interconnexion (201) ;
∘ une matrice d'au moins un pixel (10), chaque pixel (10) comprenant un photodétecteur (210), une diode électroluminescente et une région intermédiaire (390) intercalée entre le photodétecteur (210) et la diode électroluminescente, et chaque pixel étant tel que :
• le photodétecteur (210) est sensible à une longueur d'onde de détection λ₂ et comprend une surface de détection (211) s'étendant dans un plan sensiblement parallèle à un plan principal du substrat ;
• la diode électroluminescente comprend :
▪ un empilement actif (301) de longueur d'onde de coupure λ_{c} inférieure à la longueur d'onde de détection λ₂ comportant une première et une deuxième couches dopées (101.2, 101.4) de types opposés,
• une électrode enterrée (380) en contact avec la deuxième couche dopée (101.4),
• la diode électroluminescente étant agencée de telle façon que l'électrode enterrée est intercalée entre l'empilement d'interconnexion (201) et l'empilement actif (301), et recouvre la surface de détection, et tel que :
• la région intermédiaire (390) est délimitée par la surface de détection et s'étend depuis la surface de détection jusqu'à l'empilement actif (301),
le dispositif optoélectronique (1) étant **caractérisé en ce qu'**il comprend en outre :
• un via (355) traversant de part en part l'empilement actif (301) et se prolongeant jusqu'à un niveau d'interconnexion de l'empilement d'interconnexion (201) ;
• un contact électrique (357) traversant de part en part l'empilement actif (301), en contact avec l'électrode enterrée (380) ;
• un chemin électrique connectant électriquement l'électrode enterrée (380) au circuit de contrôle et comportant le contact électrique traversant (357) et le via (355) ;
et **en ce que** :
• la région intermédiaire (390) est dépourvue de métal,
• l'électrode enterrée est transparente à la longueur d'onde de détection λ₂.

2. Dispositif optoélectronique (1, 2) selon la revendication 1, tel que pour chaque pixel, la diode électroluminescente comporte :
• une région active s'étendant entre les première et deuxième couches dopées (101.2, 101.4) dans un plan sensiblement parallèle au plan principal ;
• une tranchée conductrice (358) entourant la région active et la région intermédiaire (390), traversant de part en part l'empilement actif (301) et se prolongeant jusqu'à un niveau d'interconnexion de l'empilement d'interconnexion (201) ; et
• une électrode surfacique (370) en contact avec la première couche dopée (101.2), connectée électriquement au circuit de contrôle par la tranchée conductrice (358).

3. Dispositif optoélectronique (1, 2) selon la revendication 2, tel que la tranchée conductrice (358) est revêtue d'un miroir.

4. Dispositif optoélectronique (1, 2) selon les revendications 2 ou 3, dans lequel la matrice comporte plusieurs pixels (10), et l'électrode surfacique (370) est une électrode commune à tous les pixels (10).

5. Dispositif optoélectronique (1, 2) selon la revendication 4, dans lequel les tranchées conductrices (358) de deux pixels (10) voisins ont une partie en commun.

6. Dispositif optoélectronique (1, 2) selon l'une quelconque des revendications précédentes, dans lequel la région intermédiaire (390) comprend une couche intermédiaire de fonction optique (420, 435) s'étendant parallèlement au plan principal du substrat.

7. Dispositif optoélectronique (1, 2) selon l'une quelconque des revendications précédentes dans lequel, pour chaque pixel (10), l'électrode enterrée (380) est en un oxyde d'indium-étain (ITO), en un oxyde de zinc dopé à l'aluminium (AZO) ou en dioxyde d'étain (SnO2).

8. Dispositif optoélectronique (1) selon l'une quelconque des revendications 2 à 7 dans lequel, pour chaque pixel (10), l'électrode surfacique (370) est en un oxyde d'indium-étain (ITO), en un oxyde de zinc dopé à l'aluminium (AZO ou en dioxyde d'étain (SnO2).

9. Dispositif optoélectronique (1, 2) selon l'une quelconque des revendications précédentes comprenant en outre une couche surfacique de fonction optique (430, 432) disposée sur une face du dispositif optoélectronique (1) opposée au substrat (200).

10. Dispositif optoélectronique (1, 2) selon la revendication 9, dans lequel la couche surfacique de fonction optique (432) est une couche absorbante comportant une ouverture en regard la surface de détection (211).

11. Dispositif optoélectronique (1, 2) selon l'une quelconque des revendications précédentes, comprenant en outre un élément chauffant (432) disposé sur une face du dispositif optoélectronique (1, 2) opposée au substrat (200), l'élément chauffant (432) comportant une ouverture en regard la surface de détection (211).

12. Dispositif optoélectronique (1, 2) selon l'une quelconque des revendications précédentes dans lequel, la longueur d'onde de détection λ₂ appartient au spectre visible et la diode électroluminescente est apte à émettre un flux lumineux dans la gamme des UVA.

13. Procédé de fabrication d'un dispositif optoélectronique (1, 2) selon l'une quelconque des revendications 1 à 12 comportant une diode électroluminescente et un photodétecteur (210) sensible à une longueur d'onde de détection λ₂, le procédé comprenant les étapes suivantes :
∘ fourniture d'un premier ensemble (5) comprenant, dans l'ordre, un premier substrat (100), un empilement semi-conducteur (101) et une couche conductrice inférieure (102), tel que l'empilement semi-conducteur (101) comprend une première couche dopée (101.2) d'un premier type de conductivité et une deuxième couche dopée (101.4) d'un deuxième type de conductivité opposé au premier type de conductivité, intercalée entre la première couche dopée (101.2) et le premier substrat (100), et tel que la couche conductrice inférieure (102) est en contact physique avec la deuxième couche dopée (101.4),
∘ fourniture d'un deuxième ensemble (6) comprenant un deuxième substrat (200), un circuit de contrôle et le photodétecteur (210), tel que le circuit de contrôle est intégré dans et/ou sur le deuxième substrat (200) et comporte un empilement d'interconnexion (201),
∘ report d'une face du premier ensemble opposée au premier substrat (100) sur une face du deuxième ensemble opposée au deuxième substrat (200) par collage direct mettant en oeuvre une couche de collage (303) transparente à la longueur d'onde de détection λ₂,
∘ mise à nue de la première couche dopée (101.2) comportant un retrait du premier substrat (100), pour obtenir un empilement actif (301) comportant la première couche dopée (101.2) et la deuxième couche dopée (101.4),
∘ gravure d'un premier trou (341) mettant en oeuvre un alignement du premier trou (341) par rapport à un élément du deuxième ensemble, de telle sorte que le premier trou (341) traverse de part en part l'empilement actif (301) et se prolonge jusqu'à un niveau d'interconnexion de l'empilement d'interconnexions (201),
∘ gravure d'un deuxième trou (345) mettant en oeuvre un alignement du deuxième trou (342) par rapport à un élément du deuxième ensemble, de telle sorte que le deuxième trou (345) traverse de part en part l'empilement actif (301) avec arrêt sur la couche conductrice inférieure (102),
∘ passivation du premier trou (341) et du deuxième trou (345) pour obtenir, respectivement, un premier trou (341) passivé et un deuxième trou (345) passivé,
∘ remplissage des premier et deuxième trous (341, 345) passivés avec un métal pour obtenir, respectivement, un via (355) et un contact électrique (357),
∘ formation d'une ligne conductrice (356) isolée électriquement de l'empilement actif (301) et en contact avec le contact électrique (357) et le via (355),
∘ formation d'une région active de la diode électroluminescente dans l'empilement actif (301) en regard d'une surface de détection (211) du photodétecteur (210), postérieurement à l'étape de collage, mettant en oeuvre un alignement de la région active par rapport à un élément du deuxième ensemble.

14. Procédé de fabrication selon la revendication 13 pour lequel l'étape de formation de la région active comprend une sous-étape de gravure d'une tranchée (342) traversant de part-en-part l'empilement actif (301) et se prolongeant jusqu'à un niveau d'interconnexion de l'empilement d'interconnexion (201).

15. Procédé de fabrication selon les revendications 13, ou 14 pour lequel la couche de collage inclut une couche intermédiaire de fonction optique (420, 435).
